# EUROPEAN PATENT APPLICATION

(11) **EP 4 583 642 A1**
(43) Date of publication of application: **09.07.2025**
(21) Application number: 23860048.0
(22) Date of filing: 16.08.2023
(51) Int. Cl.: H05K 1/16, B32B 15/08, H01F 1/26

(54) **MAGNETIC BOARD MANUFACTURING METHOD AND MAGNETIC BOARD**

(30) Priority: 02.09.2022 JP 2022139964
(71) Applicant: AJINOMOTO CO., INC., Chuo-ku Tokyo 104-8315 (JP)
(72) Inventor: TANAKA, Takayuki, Kawasaki-shi, Kanagawa 210-0801 (JP); MORIMOTO, Shunsuke, Kawasaki-shi, Kanagawa 210-0801 (JP); HOMMA, Tatsuya, Kawasaki-shi, Kanagawa 210-0801 (JP); OOYAMA, Hideki, Kawasaki-shi, Kanagawa 210-0801 (JP)
(74) Representative: Mewburn Ellis LLP
(86) International application number: PCT/JP2023/029610
(87) International publication number: WO 2024/048283

(57) **Abstract**

A production method of a magnetic substrate that comprises a magnetic layer and a conductor layer formed on a surface of the magnetic layer, wherein
the method comprises a step (EP) of forming the conductor layer on the surface of the magnetic layer by an electroplating,
the magnetic layer comprises a cured product of a resin composition comprising (A) a magnetic powder and (B) a thermosetting resin, and
(A) the magnetic powder comprises 30% by mass or more of (A-1) an alloy powder relative to 100% by mass of (A) the magnetic powder.

## Description

### TECHNICAL FIELD

The present invention relates to a production method of a magnetic substrate and to a magnetic substrate.

### BACKGROUND ART

A substrate having an inductor is used in many information terminals such as a mobile phone and a smart phone. In the past, an independent inductor component has been mounted on a substrate such as a circuit board. In recent years, a method of forming a coil by a conductor layer of a substrate, and thereby installing an inductor directly on the substrate has been proposed (Patent Literature 1).

### CITATION LIST

### Patent Literature

Patent Literature 1: Japanese Patent Application Laid-open No. 2021-086856

### SUMMARY OF THE INVENTION

### Technical Problem

As for the method of directly installing an inductor on the substrate, an example has been known in which a magnetic layer is formed in a hole of the substrate by a cured product of a resin composition containing a magnetic material, which is then followed by forming a conductor layer on the surface of the resulting magnetic layer. Usually, the conductor layer is formed using a plating method. Among the plating methods, by the method using an electroless plating, it is possible to form a conductor layer on the surface of a non-conductive material, but in general, it is difficult to form a thick conductor layer. On the other hand, by the method using an electroplating, which uses an electric current, in general, theoretically a conductor layer cannot be formed on the surface of a non-conductive material; thus, it has been impossible to form a conductor layer on the surface of the magnetic layer, which is a non-conductive layer. Therefore, in the past, usually, a thin conductor layer (seed layer) has formed on the surface of the magnetic layer by an electroless plating, which is then followed by forming a thick conductor layer on this thin conductor layer by an electroplating.

However, the method using the combination of the electroless plating with the electroplating requires many steps relating to formation of the conductor layer. When the number of the steps increases, the control items for plating increases, and this leads to a tendency to require a longer time for forming the conductor layer. Moreover, in general, a strict control is required in the composition of the plating solution that is used as a chemical solution for the electroless plating. Therefore, to control the composition of the plating solution requires much labor, so that the composition control of the plating solution is cumbersome.

Accordingly, it is desired to develop the technology that enables omission of the electroless plating so that a conductor layer can be formed by an electroplating on the surface of the magnetic layer.

The present invention has been conceived in view of the problem described above, and thus, an object of the present invention is to provide: a production method of a magnetic substrate, including forming a conductor layer on the surface of a magnetic layer by an electroplating; and a magnetic substrate containing a magnetic layer and a conductor layer that is formed on the surface of the magnetic layer by an electroplating.

### SOLUTION TO PROBLEM

The inventor of the present invention has extensively studied to solve the problems described above. As a result, the inventor of the present invention has found that it is possible to form a conductor layer by an electroplating on the surface of a cured product of a resin composition containing, in combination with (B) a thermosetting resin, (A) a magnetic powder that contains (A-1) an alloy powder with the amount in a particular range. Then, the inventor has found that it is possible to solve the problems described above by using the above-mentioned cured product as the magnetic layer. On the basis of this finding, the present invention has been completed.

Namely, the present invention includes the following aspects.
[1] A production method of a magnetic substrate that comprises a magnetic layer and a conductor layer formed on a surface of the magnetic layer, wherein
   the method comprises a step (EP) of forming the conductor layer on the surface of the magnetic layer by an electroplating,
   the magnetic layer comprises a cured product of a resin composition comprising (A) a magnetic powder and (B) a thermosetting resin, and
   (A) the magnetic powder comprises 30% by mass or more of (A-1) an alloy powder relative to 100% by mass of (A) the magnetic powder.
[2] The production method of the magnetic substrate according to [1], the method comprising, before the step (EP):
   a step (LF) of forming a resin composition layer that comprises the resin composition; and
   a step (CU) of curing the resin composition layer to form the magnetic layer.
[3] The production method of the magnetic substrate according to [2], wherein the method does not include, between the step (CU) and the step (EP), a step of forming the conductor layer on the surface of the magnetic layer by a method other than the electroplating.
[4] The production method of the magnetic substrate according to [2] or [3], wherein the step (LF) comprises formation of the resin composition layer in a first hole of a substrate having the first hole formed therein.
[5] The production method of the magnetic substrate according to any one of [1] to [4], wherein
   the method comprises a step (HF) of forming a second hole in the magnetic layer before the step (EP), and
   the step (EP) comprises formation of the conductor layer by the electroplating on a surface of the second hole in the magnetic layer.
[6] The production method of the magnetic substrate according to any one of [1] to [5], wherein an amount of (A) the magnetic powder relative to 100% by mass of nonvolatile components in the resin composition is 60% by mass or more.
[7] The production method of the magnetic substrate according to any one of [1] to [6], wherein a relative magnetic permeability of the cured product at a measurement frequency of 20 MHz is 10 or more.
[8] The production method of the magnetic substrate according to any one of [1] to [7], wherein (A-1) the alloy powder comprises one or more alloy powder selected from the group consisting of a Fe-Ni type alloy powder, a Fe-Cr-Si type alloy powder, and a Fe-Ni-Cr type alloy powder.
[9] A magnetic substrate comprising:
   a magnetic layer having a hole formed therein; and
   a conductor layer formed in the hole, wherein
      the magnetic layer and the conductor layer are in direct contact with each other, and there is no plating catalyst at an interface between the magnetic layer and the conductor layer,
      the magnetic layer comprises a cured product of a resin composition comprising (A) a magnetic powder and (B) a thermosetting resin, and
      (A) the magnetic powder comprises 30% by mass or more of (A-1) an alloy powder relative to 100% by mass of (A) the magnetic powder.
[10] The magnetic substrate according to [9], wherein the conductor layer is formed of copper.

### ADVANTAGEOUS EFFECTS OF INVENTION

According to the present invention, what is provided are: a production method of a magnetic substrate, the method including forming a conductor layer on the surface of a magnetic layer by an electroplating; and a magnetic substrate including a magnetic layer and a conductor layer formed on the surface of the magnetic layer by an electroplating.

### BRIEF DESCRIPTION OF DRAWINGS

FIG. 1 is a schematic cross-sectional view to explain the step in the production method of the magnetic substrate according to one example.
FIG. 2 is a schematic cross-sectional view to explain the step in the production method of the magnetic substrate according to one example.
FIG. 3 is a schematic cross-sectional view to explain the step in the production method of the magnetic substrate according to one example.
FIG. 4 is a schematic cross-sectional view to explain the step in the production method of the magnetic substrate according to one example.
FIG. 5 is a schematic cross-sectional view to explain the step in the production method of the magnetic substrate according to one example.
FIG. 6 is a schematic cross-sectional view to explain the step in the production method of the magnetic substrate according to one example.
FIG. 7 is a schematic cross-sectional view to explain the step in the production method of the magnetic substrate according to one example.
FIG. 8 is a schematic cross-sectional view to explain the step in the production method of the magnetic substrate according to one example.
FIG. 9 is a schematic cross-sectional view to explain the step in the production method of the magnetic substrate according to one example.
FIG. 10 is a schematic cross-sectional view to explain the step in the production method of the magnetic substrate according to one example.
FIG. 11 is a schematic cross-sectional view to explain the step in the production method of the magnetic substrate according to one example.
FIG. 12 is a schematic cross-sectional view of the magnetic substrate according to one example.

### DESCRIPTION OF EMBODIMENTS

Hereinafter, the present invention will be described in detail by embodiments and examples. The present invention is not limited to the embodiments and examples described below; thus, the present invention may be carried out with any modification as long as such modification is not outside the claims or the equivalent thereof.

In the explanation hereinafter, "resin component" in the resin composition means the components excluding inorganic particles such as (A) a magnetic powder from the nonvolatile components included in the resin composition, unless otherwise specifically mentioned.

### [Outline of the production method of the magnetic substrate]

The production method according to one embodiment of the present invention is the production method of the magnetic substrate including a magnetic layer and a conductor layer formed on a surface of the magnetic layer. The magnetic layer contains a cured product of a resin composition containing (A) a magnetic powder and (B) a thermosetting resin. (A) The magnetic powder contains (A-1) an alloy powder with the amount thereof in a particular range. Because it is possible to form a conductor layer on the surface of the magnetic layer described above by an electroplating, it is possible to omit the formation of a conductor layer (seed layer) by an electroless plating. Therefore, the production method according to the present embodiment can include the step (EP) of forming the conductor layer on the surface of the magnetic layer by an electroplating. Hereinafter, the aforementioned conductor layer formed on the surface of the magnetic layer by an electroplating may be referred to as "electroplated layer".

According to the production method of the present embodiment, because it is possible to omit the formation of the conductor layer (seed layer) by an electroless plating, the number of the steps can be reduced, thereby enabling to form the electroplated layer conveniently and in a short time. In addition, because the electroless plating is not required, a chemical solution for the electroless plating is not required. Therefore, there is no need to control the composition of the chemical solution, and thus the process for producing the magnetic substrate can be made simple. This is in sharp contrast to the use of a chemical solution in the electroless plating, in which dissolution of (A-1) the alloy powder into the chemical solution may occur depending on the type of (A-1) the alloy powder, resulting in the increase of the cumbersomeness in the control of the composition of the chemical solution. In addition, even particles of the material that may be dissolved in or deteriorated by the chemical solution can be used as (A-1) the alloy powder as well, thereby expanding the selection range of (A-1) the alloy powder. This usually allows for the magnetic layer containing (A-1) the alloy powder to have excellent magnetic properties.

In general, in the electroplating, a metal ion in a plating solution is reduced and deposited on the surface of the cathode, which serves as the plating target, to form a conductor layer. Because the reduction of a metal ion requires applying of an electric current, it has been a conventional technical common sense among those skilled in the art that the reduction of the metal ion occurs only on the surface of a cathode formed by a conductor. For example, even when the electroplating is attempted, it has been impossible to form a conductor layer on the surface of a conventional magnetic layer, which has a high volume resistance.

On the contrary, according to the present embodiment, it is possible to form the electroplated layer as the conductor layer on the surface of the magnetic layer by the electroplating even though the magnetic layer containing (A) the magnetic powder that contains (A-1) the alloy powder with the amount in a particular range has a greater resistance than the conductor. Even when the magnetic layer according to the present embodiment has the same volume resistance as the conventional magnetic layer, it is possible to form the electroplated layer by the electroplated layer on the surface of the magnetic layer according to the present embodiment containing (A) the magnetic powder that contains (A-1) the alloy powder with the amount in a particular range. This phenomenon is surprising to those skilled in the art.

Although the present invention is not bound by any particular theory, the inventor presumes the mechanism by which the electroplated layer is formed on the surface of the magnetic layer by the electroplating as described above as follows.

Assume that a wiring is connected to the magnetic layer for the electroplating. In general, (A-1) the alloy powder has electrical conductivity, but all or most of the particles of (A-1) the alloy powder are usually insulated from each other by a resin component. Therefore, the magnetic layer is usually insulating. However, in the magnetic layer containing large amount of (A) the magnetic powder so as to have a high relative magnetic permeability required for the magnetic substrate, the particles of (A-1) the alloy powder in (A) the magnetic powder are close to each other in the distance. Then, when a sufficient voltage is applied, an insulation breakdown of the resin component occurs, and thus an electric current can flow between the particles of (A-1) the alloy powder. Moreover, when there are areas in the magnetic layer where the particles of (A-1) the alloy powder are in contact with each other, these particles of (A-1) the alloy powder can form a conductive path. Through the conductive path, an electric current can flow. When the electric current flows, a metal ion is reduced on the surface of the particles of (A-1) the alloy powder through which the electric current flows, resulting in deposition of the metal on it. Therefore, the electroplating in which the magnetic layer functions as a cathode becomes possible, thereby enabling to form the electroplated layer without conducting the electroless plating.

The production method according to the present embodiment may include, before the step (EP), a step (LF) of forming a resin composition layer containing the resin composition and a step (CU) of curing the resulting resin composition layer to form a magnetic layer. Therefore, the production method according to the present embodiment may include the step (LF) of forming a resin composition layer, the step (CU) of curing the resin composition layer to form a magnetic layer, and the step (EP) of forming an electroplated layer on the surface of the magnetic layer by the electroplating, in this order. In this case, according to the production method of the present embodiment, it is possible to produce the magnetic substrate without including, between the step (CU) and the step (EP), a step of forming a conductor layer on the surface of the magnetic layer by a method other than the electroplating.

### [Resin composition]

Hereinafter, the resin composition used in the production method of the magnetic substrate according to one embodiment of the present invention will be described. The resin composition according to the present embodiment contains (A) a magnetic powder and (B) a thermosetting resin. The resin composition may also contain an optional component in combination with (A) the magnetic powder and (B) the thermosetting resin.

### <(A) Magnetic powder>

The resin composition according to the present embodiment contains (A) a magnetic powder as the component (A). (A) The magnetic powder may be a particle of the material having a relative magnetic permeability of more than 1. Usually, the material of (A) the magnetic powder is an inorganic material, and may be any of a soft magnetic material and a hard magnetic material. The material of (A) the magnetic powder may be used singly or in a combination of two or more of them. Therefore, (A) the magnetic powder may be any of a soft magnetic powder, a hard magnetic powder, and a combination of a soft magnetic powder and a hard magnetic powder. In particular, it is preferable that (A) the magnetic powder contains a soft magnetic powder, and it is more preferable that (A) the magnetic powder contains only a soft magnetic powder. (A) The magnetic powder may be used singly or in a combination of two or more of them.

(A) The magnetic powder contains (A-1) an alloy powder. (A-1) The alloy powder as the component (A-1) is a particle of an alloy. Illustrative examples of (A-1) the alloy powder may include a Fe-Si type alloy powder, a Fe-Si-Al type alloy powder, a Fe-Cr type alloy powder, a Fe-Cr-Si type alloy powder, a Fe-Ni-Cr type alloy powder, a Fe-Cr-Al type alloy powder, a Fe-Ni type alloy powder, a Fe-Ni-Si type alloy powder, a Fe-Ni-B type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder. The alloy that is included in (A-1) the alloy powder may be crystalline, amorphous, or a combination of these.

In particular, as for (A-1) the alloy powder, an iron alloy powder as the particle of the alloy containing iron is more preferable. Among the iron alloy powders, an iron alloy powder containing an element Fe as well as at least one element selected from the group consisting of Ni, Cr, and Si is more preferable; and at least one iron alloy powder selected from the group consisting of a Fe-Ni type alloy powder, a Fe-Cr-Si type alloy powder, and a Fe-Ni-Cr type alloy powder is especially preferable. The Fe-Ni type alloy powder represents the alloy powder containing Fe and Ni. The Fe-Cr-Si type alloy powder represents the alloy powder containing Fe, Cr, and Si. The Fe-Ni-Cr type alloy powder represents the alloy powder containing Fe, Ni, and Cr. When these preferable (A-1) alloy powders are used, a magnetic layer having excellent magnetic properties can be obtained, and the electroplated layer can be formed on the surface of the magnetic layer by the electroplating without much problem.

As for (A-1) the alloy powder, a commercially available product may be used. Illustrative examples of the commercially available (A-1) the alloy powder may include: "AKT-PB(5)" (Fe-Ni type alloy powder) and "AKT-PB-3Si(5)" (Fe-Ni-Si type alloy powder) manufactured by Mitsubishi Steel Mfg. Co., Ltd.; "CVD Iron Powder" (Fe-Cr-Si type alloy powder) manufactured by JFE Mineral & Alloy Co., Ltd.; "AW2-08 PF3F" (Fe-Si-Cr type alloy powder) manufactured by Epson Atmix Corp.; and "MA-RCO-5" (Fe-Ni-B type alloy) and "MA RCO-24" (Fe-Ni type alloy) manufactured by Dowa Electronics Materials Co.

(A-1) The alloy powder may be used singly or in a combination of two or more of them.

It is preferable that (A-1) the alloy powder has an average particle diameter within a particular range. The range of the average particle diameter of (A-1) the alloy powder is preferably 0.001 µm or more, more preferably 0.01 µm or more, and still more preferably 0.1 µm or more, and is preferably 800 µm or less, more preferably 300 µm or less, and still more preferably 100 µm or less. When (A-1) the alloy powder having the average particle diameter within the above-mentioned range is used, the magnetic layer having excellent magnetic properties can be obtained, and the electroplated layer can be formed on the surface of the magnetic layer by the electroplating without much problem.

The average particle diameter is the median diameter on a volume basis, unless otherwise specifically mentioned. The average particle diameter can be measured with a laser diffraction scattering method based on the Mie scattering theory. Specifically, the particle diameter distribution thereof is prepared on a volume basis by using a laser diffraction scattering type particle diameter distribution analyzer, in which the median diameter thereof can be measured as the average particle diameter. The powders that are dispersed in water by means of an ultrasonic wave can be suitably used as the measurement sample. Illustrative examples of the laser diffraction scattering type particle diameter distribution analyzer that can be used may include "LA-500" manufactured by Horiba Ltd. and "SALD-2200" manufactured by Shimadzu Corp.

From the viewpoint of increasing a relative magnetic permeability, the specific surface area of (A-1) the alloy powder is preferably 0.05 m²/g or more, more preferably 0.1 m²/g or more, and still more preferably 0.3 m²/g or more, and is preferably 10 m²/g or less, more preferably 8 m²/g or less, and still more preferably 5 m²/g or less. The specific surface area of (A-1) the alloy powder can be measured by the BET method. Specifically, the specific surface area can be measured according to the BET method by adsorbing a nitrogen gas onto the sample surface using a specific surface area measurement instrument ("Macsorb HM Model 1210" manufactured by Mountech Co., Ltd.) with the BET multipoint method.

The particle of (A-1) the alloy powder is preferably spherical or ellipsoidal. The range of the ratio (aspect ratio) that is obtained by dividing the length of the longitude axis by the length of the short axis of the particles of the (A-1) the alloy powder is preferably 2 or less, more preferably 1.5 or less, and still more preferably 1.2 or less, and is usually 1.0 or more. In general, when the particle shape of the magnetic powder is not spherical but flat, a relative magnetic permeability can be readily increased. On the other hand, when the particle shape of the magnetic powder is close to a spherical shape, the magnetic loss can be readily decreased.

The range of the true specific gravity of (A-1) the alloy powder may be, for example, in the range of 4 g/cm³ to 10 g/cm³.

(A) The magnetic powder contains (A-1) the alloy powder with the amount in a particular range. Specifically, the range of the amount (% by mass) of (A-1) the alloy powder relative to 100% by mass of (A) the magnetic powder is usually 30% by mass or more, preferably 40% by mass or more, and more preferably 50% by mass or more; this may be even 60% by mass or more. The upper limit thereof is usually 100% by mass or less. When (A-1) the alloy powder with the amount in the above-mentioned range is used, it is possible to form the electroplated layer on the surface of the magnetic layer by the electroplating. In addition, usually it is possible to obtain the magnetic layer having excellent magnetic properties. Furthermore, preferably it is possible to improve the surface smoothness of the resulting electroplated layer.

The range of the amount (% by volume) of (A-1) the alloy powder relative to 100% by volume of (A) the magnetic powder is preferably 20% by volume or more, more preferably 30% by volume or more, and still more preferably 40% by volume or more; this may be even 50% by volume or more. The upper limit thereof is usually 100% by volume or less. When (A-1) the alloy powder with the amount in the above-mentioned range is used, it is possible to obtain the magnetic layer having excellent magnetic properties, and the electroplated layer can be formed on the surface of the magnetic layer by the electroplating without much problem. Furthermore, preferably it is possible to improve the surface smoothness of the resulting electroplated layer.

The amount of each component included in the resin composition on the volume basis (% by volume) may be determined by calculation from the mass of the component included in the resin composition. Specifically, the volume of each component is obtained by dividing the mass with the specific gravity; and the amount based on the volume (% by volume) can be calculated from the volume of each component obtained.

The range of the amount (% by mass) of (A-1) the alloy powder relative to 100% by mass of the nonvolatile components in the resin composition is preferably 10% by mass or more, more preferably 15% by mass or more, and still more preferably 20% by mass or more, and is preferably 99% by mass or less, more preferably 98% by mass or less, and still more preferably 97% by mass or less. When (A-1) the alloy powder with the amount in the above-mentioned range is used, it is possible to obtain the magnetic layer having excellent magnetic properties, and the electroplated layer can be formed on the surface of the magnetic layer by the electroplating without much problem. Furthermore, preferably it is possible to improve the surface smoothness of the resulting electroplated layer.

The range of the amount (% by volume) of (A-1) the alloy powder relative to 100% by volume of the nonvolatile components in the resin composition is preferably 10% by volume or more, more preferably 13% by volume or more, and still more preferably 16% by volume or more, and is preferably 90% by volume or less, more preferably 85% by volume or less, and still more preferably 80% by volume or less. When (A-1) the alloy powder with the amount in the above-mentioned range is used, it is possible to obtain the magnetic layer having excellent magnetic properties, and the electroplated layer can be formed on the surface of the magnetic layer by the electroplating without much problem. Furthermore, preferably it is possible to improve the surface smoothness of the resulting electroplated layer.

(A) The magnetic powder may contain (A-2) an optional magnetic powder other than (A-1) the alloy powder. Illustrative examples of (A-2) the optional magnetic powder may include a magnetic metal oxide powder and a magnetic metal powder other than (A-1) the alloy powder.

Illustrative examples of the magnetic metal oxide powder may include ferrite powders such as a Fe-Mn type ferrite powder, a Fe-Mn-Mg type ferrite powder, a Fe-Mn-Mg-Sr type ferrite powder, a Fe-Mg-Zn type ferrite powder, a Fe-Mg-Sr type ferrite powder, a Fe-Zn-Mn type ferrite powder, a Fe-Cu-Zn type ferrite powder, a Fe-Ni-Zn type ferrite powder, a Fe-Ni-Zn-Cu type ferrite powder, a Fe-Ba-Zn type ferrite powder, a Fe-Ba-Mg type ferrite powder, a Fe-Ba-Ni type ferrite powder, a Fe-Ba-Co type ferrite powder, a Fe-Ba-Ni-Co type ferrite powder, and a Fe-Y type ferrite powder; and iron oxide powders such as an iron (III) oxide powder and a tri-iron tetraoxide powder.

The magnetic metal powder other than (A-1) the alloy powder may include, for example, a pure iron powder.

Among (A-2) the optional magnetic powders, a magnetic metal oxide powder is preferable, and a ferrite powder is more preferable. Usually, the ferrite powder is formed of a composite oxide containing an iron oxide as the main component, and is chemically stable. Therefore, the ferrite powder offers advantages such as a high corrosion resistance, a low risk of ignition, and a resistance to demagnetization. Among them, the ferrite powders containing at least one element selected from the group consisting of Mn and Zn are preferable, and the ferrite powders containing Mn are more preferable, and a Fe-Mn type ferrite powder and a Fe-Mn-Zn type ferrite powder are particularly preferable. The Fe-Mn type ferrite powder represents the ferrite powder containing Fe and Mn, and the Fe-Mn-Zn type ferrite powder represents the ferrite powder containing Fe, Mn, and Zn.

As for (A-2) the optional magnetic powder, a commercially available product may be used. Illustrative examples of (A-2) the optional magnetic powder that is commercially available may include "M001", "M03S", "M05S", "MZ03S", and "MZ05S", manufactured by Powdertech Co., Ltd.; "AW2-08" manufactured by Epson Atmix Corp.; "LD-M", "LD-MH", "KNI-106", "KNI-106GSM", "KNI-106GS", "KNI-109", and "KNI-109GSM", manufactured by JFE Chemical Corp.; and "KNS-415", "BSF-547", "BSF-029", "BSN-125", "BSN-714", and "BSN-828", manufactured by Toda Kogyo Corp.

(A-2) The optional magnetic powder may be used singly or in a combination of two or more of them.

The average particle diameter of (A-2) the optional magnetic powder is not particularly restricted. The average particle diameter of (A-2) the optional magnetic powder is preferably less than the average particle diameter of (A-1) the alloy powder. (A-2) The optional magnetic powder that is smaller than (A-1) the alloy powder can enter the spaces among the particles of (A-1) the alloy powder. Therefore, the filling density of (A) the magnetic powder in the magnetic layer as a whole is increased, resulting in excellent enhancement of the magnetic properties thereof. According to the small (A-2) optional magnetic powder as described above, the distance between particles of (A-1) the alloy powder is restrained from expanding by the excluding volume of the particles of (A-2) the optional magnetic powder, thereby allowing the electric current to flow more smoothly during the electroplating, which in turn allowing an efficient forming of the electroplated layer. Specifically, the range of the average particle diameter of (A-2) the optional magnetic powder is preferably 0.001 µm or more, more preferably 0.01 µm or more, and still more preferably 0.1 µm or more, and is preferably 500 µm or less, more preferably 100 µm or less, and still more preferably 50 µm or less.

The specific surface area of (A-2) the optional magnetic powder is not particularly restricted. From the viewpoint of enhancing the relative magnetic permeability, the range of the specific surface area of (A-2) the optional magnetic powder is preferably the same as the range of the specific surface area of (A-1) the alloy powder.

The shape of (A-2) the optional magnetic powder is not particularly restricted. For example, (A-2) the optional magnetic powder may have the same shape as the particles of (A-1) the alloy powder. Therefore, the range of the aspect ratio of the particle of (A-2) the optional magnetic powder may be the same as the range of the aspect ratio of the particle of (A-1) the alloy powder.

The true specific gravity of (A-2) the optional magnetic powder is not particularly restricted. For example, the range of the true specific gravity of (A-2) the optional magnetic powder may be the same as the range of the true specific gravity of (A-1) the alloy powder.

The range of the amount (% by mass) of (A) the magnetic powder relative to 100% by mass of the nonvolatile components in the resin composition is preferably 60% by mass or more, more preferably 70% by mass or more, and still more preferably 80% by mass or more, and is preferably 99% by mass or less, more preferably 98% by mass or less, and still more preferably 97% by mass or less. When the amount of (A) the magnetic powder as a whole, including (A-1) the alloy powder and (A-2) the optional magnetic powder, is within the above-mentioned range, the magnetic layer having excellent magnetic properties can be obtained, and the electroplated layer can be formed on the surface of the magnetic layer by the electroplating without much problem. In particular, from the viewpoint of enhancing the smoothness of the electroplated layer, the amount (% by mass) of (A) the magnetic powder is preferably 85% by mass or more. When the amount of (A) the magnetic powder is so much as described above, it is possible to densely distribute (A-1) the alloy powder, which serves as the initial deposition point for the metal ion to form the electroplated layer, thereby decreasing the degree of the variation in deposition and realizing the efficient formation of the electroplated layer having a smooth surface.

The range of the amount (% by volume) of (A) the magnetic powder relative to 100% by volume of the nonvolatile components in the resin composition is preferably 30% by volume or more, more preferably 40% by volume or more, and still more preferably 50% by volume or more, and is preferably 90% by volume or less, more preferably 85% by volume or less, and still more preferably 80% by volume or less. When the amount of (A) the magnetic powder as a whole, including (A-1) the alloy powder and (A-2) the optional magnetic powder, is within the above-mentioned range, the magnetic layer having excellent magnetic properties can be obtained, and the electroplated layer can be formed on the surface of the magnetic layer by the electroplating without much problem. In particular, from the viewpoint of enhancing the smoothness of the electroplated layer, the amount (% by volume) of (A) the magnetic powder is preferably 55% by volume or more. When the amount of (A) the magnetic powder is so much as described above, it is possible to densely distribute (A-1) the alloy powder, which serves as the initial deposition point for the metal ion to form the electroplated layer, thereby decreasing the degree of the variation in deposition and realizing the efficient formation of the electroplated layer having a smooth surface.

### <(B) Thermosetting resin>

The resin composition according to the present embodiment contains (B) a thermosetting resin as the component (B). Usually, (B) the thermosetting resin can bind (A) the magnetic powder. In addition, (B) the thermosetting resin can undergo a reaction by heat to form a bond, with which the resin composition can be cured. Therefore, the resin composition containing (A) the magnetic powder and (B) the thermosetting resin in combination can cure to form a cured product. The magnetic layer can be formed by this cured product.

Illustrative examples of (B) the thermosetting resin may include an epoxy resin, a phenol type resin, an active ester type resin, an amine type resin, an acid anhydride type resin, a benzoxazine type resin, a cyanate ester type resin, and a carbodiimide type resin. (B) The thermosetting resin may be used singly or in a combination of two or more of them.

It is preferable that (B) the thermosetting resin includes (B-1) an epoxy resin. (B-1) The epoxy resin represents the resin having one or more epoxy groups in the molecule. Illustrative examples of (B-1) the epoxy resin may include a bixylenol type epoxy resin; a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenolic novolac type epoxy resin; a glycidylamine type epoxy resin; a glycidyl ester type epoxy resin; a cresol novolac type epoxy resin; a biphenyl type epoxy resin; a linear aliphatic epoxy resin; an epoxy resin containing a butadiene structure; an alicyclic epoxy resin; an alicyclic epoxy resin containing an ester skeleton; a heterocyclic epoxy resin; an epoxy resin containing a spiro ring; a cyclohexane type epoxy resin; a cyclohexane dimethanol type epoxy resin; a trimethylol type epoxy resin; a tetraphenylethane type epoxy resin; epoxy resins containing a fused ring skeleton such as a naphthylene ether type epoxy resin, a tert-butyl-catechol type epoxy resin, a naphthalene type epoxy resin, a naphthol type epoxy resin, an anthracene type epoxy resin, and a naphthol novolac type epoxy resin; an isocyanurate type epoxy resin; an epoxy resin containing an alkyleneoxy skeleton and a butadiene skeleton; and an epoxy resin containing a fluorene structure. (B-1) The epoxy resin may be used singly or in a combination of two or more of them.

It is preferable that (B-1) the epoxy resin includes an epoxy resin having two or more epoxy groups in one molecule thereof. The ratio of the epoxy resin having two or more epoxy groups in one molecule thereof relative to 100% by mass of the total amount of (B-1) the epoxy resin is preferably 50% by mass or more, more preferably 60% by mass or more, and still more preferably 70% by mass or more.

It is preferable that (B-1) the epoxy resin contains an aromatic structure. When two or more epoxy resins are used, it is preferable that one or more epoxy resins contain the aromatic structure. The aromatic structure is the chemical structure that is generally defined as aromatic, including a polycyclic aromatic ring and an aromatic heterocycle.

In (B-1) the epoxy resin, there are an epoxy resin that is in the state of liquid at 20°C (hereinafter, this may be referred to as "liquid epoxy resin") and an epoxy resin that is in the state of solid at 20°C (hereinafter, this may be referred to as "solid epoxy resin"). (B-1) The epoxy resin may be only the liquid epoxy resin, or only the solid epoxy resin, or a combination of the liquid epoxy resin and the solid epoxy resin. Among them, (B-1) the epoxy resin preferably includes the liquid epoxy resin, and especially preferably includes only the liquid epoxy resin.

As for the liquid epoxy resin, the liquid epoxy resin having two or more epoxy groups in one molecule thereof is preferable. The liquid epoxy resin is preferably a bisphenol A type epoxy resin, a bisphenol F type epoxy resin, a bisphenol AF type epoxy resin, a naphthalene type epoxy resin, a glycidyl ester type epoxy resin, a glycidylamine type epoxy resin, a phenol novolac type epoxy resin, an alicyclic epoxy resin containing an ester skeleton, a cyclohexane type epoxy resin, a cyclohexane dimethanol type epoxy resin, an epoxy resin containing a butadiene structure, an epoxy resin containing an alkyleneoxy skeleton and a butadiene skeleton, an epoxy resin containing a fluorene structure, and a dicyclopentadiene type epoxy resin. Among them, a bisphenol A type epoxy resin, a bisphenol F type epoxy resin, a glycidylamine type epoxy resin, and a cyclohexane type epoxy resin are especially preferable.

Specific examples of the liquid epoxy resin may include "YX7400" manufactured by Mitsubishi Chemical Corp.; "HP4032", "HP4032D", and "HP4032SS", manufactured by DIC Corp. (naphthalene type epoxy resin); "828US", "828EL", "jER828EL", "825", and "Epikote 828EL", manufactured by Mitsubishi Chemical Corp. (bisphenol A type epoxy resin); "jER807" and "1750", manufactured by Mitsubishi Chemical Corp. (bisphenol F type epoxy resin); "jER152" manufactured by Mitsubishi Chemical Corp. (phenol novolac type epoxy resin); "630", "630LSD", and "604", manufactured by Mitsubishi Chemical Corp. (glycidylamine type epoxy resin); "ED-523T" manufactured by Adeka Corp. (glycyrol type epoxy resin); "EP-3950L" and "EP-3980S", manufactured by Adeka Corp. (glycidylamine type epoxy resin); "EP-4088S" manufactured by Adeka Corp. (dicyclopentadiene type epoxy resin); "ZX-1059" manufactured by Nippon Steel Chemical & Material Co., Ltd. (mixture of bisphenol A type epoxy resin and bisphenol F type epoxy resin); "EX-721" manufactured by Nagase ChemteX Corp. (glycidyl ester type epoxy resin); "EX-991L" manufactured by Nagase ChemteX Corp. (epoxy resin containing an alkyleneoxy skeleton); "Celloxide 2021P" and "Celloxide 2081", manufactured by Daicel Corp. (alicyclic epoxy resin containing ester skeleton); "PB-3600" manufactured by Daicel Corp., "JP-100" and "JP-200", manufactured by Nippon Soda Co., Ltd. (epoxy resin containing butadiene structure); "ZX1658" and "ZX1658GS", manufactured by Nippon Steel Chemical & Material Co., Ltd. (liquid 1,4-glycidylcyclohexane type epoxy resin); and "EG-280" manufactured by Osaka Gas Chemicals Co., Ltd. (epoxy resin containing fluorene structure). These liquid epoxy resins may be used singly or in a combination of two or more of them.

As for the solid epoxy resin, the solid epoxy resin having three or more epoxy groups in one molecule thereof is preferable; the aromatic solid epoxy resin having three or more epoxy groups in one molecule thereof is more preferable. The solid epoxy resin is preferably a bixylenol type epoxy resin, a naphthalene type epoxy resin, a naphthalene type four-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, or a tetraphenylethane type epoxy resin; among these, the dicyclopentadiene type epoxy resin is especially preferable.

Specific examples of the solid epoxy resin may include "HP4032H" manufactured by DIC Corp. (naphthalene type epoxy resin); "HP-4700" and "HP-4710" manufactured by DIC Corp. (naphthalene type four-functional epoxy resin); "N-690" manufactured by DIC Corp. (cresol novolac type epoxy resin); "N-695" manufactured by DIC Corp. (cresol novolac type epoxy resin); "HP-7200", "HP-7200HH", and "HP-7200H" manufactured by DIC Corp. (dicyclopentadiene type epoxy resin); "EXA-7311", "EXA-7311-G3", "EXA-7311-G4", "EXA-7311-G4S", and "HP6000" manufactured by DIC Corp. (naphthylene ether type epoxy resin); "EPPN-502H" manufactured by Nippon Kayaku Co., Ltd. (trisphenol type epoxy resin); "NC7000L" manufactured by Nippon Kayaku Co., Ltd. (naphthol novolac type epoxy resin); "NC3000H", "NC3000", "NC3000L", and "NC3100" manufactured by Nippon Kayaku Co., Ltd. (biphenyl type epoxy resin); "ESN475V" manufactured by Nippon Steel Chemical & Material Co., Ltd. (naphthol type epoxy resin); "ESN485" manufactured by Nippon Steel Chemical & Material Co., Ltd. (naphthol novolac type epoxy resin); "YL6121" manufactured by Mitsubishi Chemical Corp. (biphenyl type epoxy resin); "YX4000H", "YX4000", and "YX4000HK" manufactured by Mitsubishi Chemical Corp. (bixylenol type epoxy resin); "YX8800" manufactured by Mitsubishi Chemical Corp. (anthracene type epoxy resin); "YX7700" manufactured by Mitsubishi Chemical Corp. (novolac type epoxy resin containing a xylene structure); "PG-100" and "CG-500", manufactured by Osaka Gas Chemicals Co., Ltd.; "YL7760" manufactured by Mitsubishi Chemical Corp. (bisphenol AF type epoxy resin); "YL7800" manufactured by Mitsubishi Chemical Corp. (fluorene type epoxy resin); "jER1010" manufactured by Mitsubishi Chemical Corp. (solid bisphenol A type epoxy resin); and "jER1031S" (tetraphenylethane type epoxy resin) manufactured by Mitsubishi Chemical Corp. These solid epoxy resins may be used singly or in a combination of two or more of them.

In the case where the epoxy resin is used in a combination of the liquid epoxy resin and the solid epoxy resin, the mass ratio of the liquid epoxy resin with respect to the solid epoxy resin (liquid epoxy resin/solid epoxy resin) is preferably 0.5 or more, more preferably 1 or more, still more preferably 5 or more, and still more preferably 10 or more.

The epoxy equivalent of (B-1) the epoxy resin is preferably in the range of 50 g/eq. to 5000 g/eq., more preferably in the range of 60 g/eq. to 3000 g/eq., still more preferably in the range of 80 g/eq. to 2000 g/eq., and far still more preferably in the range of 110 g/eq. to 1000 g/eq. The epoxy equivalent is the mass of the resin per one equivalent of the epoxy group. The epoxy equivalent can be measured by the method in accordance with JIS K7236.

The weight-average molecular weight (Mw) of (B-1) the epoxy resin is preferably in the range of 100 to 5000, more preferably in the range of 250 to 3000, and still more preferably in the range of 400 to 1500. The weight-average molecular weight of the resin can be measured in terms of polystyrene by a gel permeation chromatography (GPC) method.

The range of the amount (% by mass) of (B-1) the epoxy resin included in the resin composition is preferably 0.1% by mass or more, more preferably 0.5% by mass or more, and still more preferably 1% by mass or more, and is preferably 20% by mass or less, more preferably 15% by mass or less, and still more preferably 10% by mass or less, relative to 100% by mass of the nonvolatile components in the resin composition. When the amount of (B-1) the epoxy resin is within the above-mentioned range, the magnetic layer having excellent magnetic properties can be obtained, and the electroplated layer can be formed on the surface of the magnetic layer by the electroplating without much problem.

The range of the amount (% by mass) of (B-1) the epoxy resin included in the resin composition is preferably 10% by mass or more, more preferably 20% by mass or more, and still more preferably 30% by mass or more, and is preferably 96% by mass or less, more preferably 93% by mass or less, and still more preferably 90% by mass or less, relative to 100% by mass of the resin components in the resin composition. When the amount of (B-1) the epoxy resin is within the above-mentioned range, the magnetic layer having excellent magnetic properties can be obtained, and the electroplated layer can be formed on the surface of the magnetic layer by the electroplating without much problem.

The range of the amount (% by mass) of (B-1) the epoxy resin included in the resin composition is preferably 0.1% by mass or more, more preferably 0.5% by mass or more, and still more preferably 1% by mass or more, and is preferably 20% by mass or less, more preferably 16% by mass or less, and still more preferably 12% by mass or less, relative to 100% by mass of (A) the magnetic powder. When the amount of (B-1) the epoxy resin is within the above-mentioned range, the magnetic layer having excellent magnetic properties can be obtained, and the electroplated layer can be formed on the surface of the magnetic layer by the electroplating without much problem.

When (B) the thermosetting resin contains (B-1) the epoxy resin, it is preferable that (B) the thermosetting resin contains a resin that is capable of undergoing the reaction with (B-1) the epoxy resin to form a bond. Hereinafter, the resin that is capable of undergoing the reaction with (B-1) the epoxy resin to form a bond may be referred to as "(B-2) curing agent". Illustrative examples of (B-2) the curing agent may include a phenol type resin, an active ester type resin, an amine type resin, a carbodiimide type resin, an acid anhydride type resin, a benzoxazine type resin, a cyanate ester type resin, and a thiol type resin. The (B-2) curing agent may be used singly or in a combination of two or more of them. In particular, a phenol type resin is preferable.

As for the phenol type resin, a resin having one or more, preferably two or more, hydroxyl groups bonding to an aromatic ring such as a benzene ring or a naphthalene ring in one molecule thereof may be used. In view of the heat resistance and the water resistance, a phenol type resin containing a novolac structure is preferable. In view of the adhesion property, a nitrogen-containing phenol type resin is preferable, and a phenol type resin containing a triazine skeleton is more preferable. In particular, from the viewpoint of highly satisfying a heat resistance, a water resistance, and an adhesion property, a phenol novolac resin containing a triazine skeleton is preferable.

Specific examples of the phenol type resin may include "MEH-7700", "MEH-7810", "MEH-7851", and "MEH-8000H", manufactured by Meiwa Plastic Industries, Ltd.; "NHN", "CBN", and "GPH", manufactured by Nippon Kayaku Co., Ltd.; "SN-170", "SN-180", "SN-190", "SN-475", "SN-485", "SN-495", "SN-495V", "SN-375", and "SN-395", manufactured by Nippon Steel Chemical & Material Co., Ltd.; "TD-2090", "TD-2090-60M", "LA-7052", "LA-7054", "LA-1356", "LA-3018", "LA-3018-50P", "EXB-9500", "HPC-9500", "KA-1160", "KA-1163", and "KA-1165", manufactured by DIC Corp.; and "GDP-6115L", "GDP-6115H", and "ELPC75", manufactured by Gunei Chemical Industry Co., Ltd.

As for the active ester type resin, a compound having one or more, and preferably two or more, active ester groups in one molecule thereof may be used. Among the active ester type resins, the compound having two or more highly reactive ester groups in one molecule thereof are preferable as the active ester type resin, such as a phenol ester type compound, a thiophenol ester type compound, an N-hydroxylamine ester type compound, and an ester compound of a heterocyclic hydroxy compound. The active ester type resin is preferably the compound that is obtained by condensation reaction of a carboxylic acid compound and/or a thiocarboxylic acid compound with a hydroxy compound and/or a thiol compound. Especially, from the viewpoint of improvement of a heat resistance, an active ester type resin obtained from a carboxylic acid compound and a hydroxy compound is preferable, while an active ester type resin obtained from a carboxylic acid compound and a phenol compound and/or a naphthol compound is more preferable. Illustrative examples of the carboxylic acid compound may include benzoic acid, acetic acid, succinic acid, maleic acid, itaconic acid, phthalic acid, isophthalic acid, terephthalic acid, and pyromellitic acid. Illustrative examples of the phenol compound or the naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolac. Here, the "dicyclopentadiene type diphenol compound" means a diphenol compound obtained by condensation of one dicyclopentadiene molecule with two phenol molecules.

Specific examples of the preferable active ester type resin may include an active ester type resin containing a dicyclopentadiene type diphenol structure, an active ester type resin containing a naphthalene structure, an active ester type resin containing an acetylated phenol novolac, and an active ester type resin containing a benzoylated phenol novolac. Among them, the active ester type resin containing a naphthalene structure and the active ester type resin containing a dicyclopentadiene type diphenol structure are more preferable. Here, the "dicyclopentadiene type diphenol structure" means the divalent structure unit formed of phenylene-dicyclopentylene-phenylene.

Illustrative examples of the commercially available active ester type resin may include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (manufactured by DIC Corp.); active ester type resins containing a naphthalene structure, such as "EXB-9416-70BK", "EXB-8150-65T", "EXB-8100L-65T", and "EXB-8150L-65T" (manufactured by DIC Corp.); active ester type resins containing an acetylated phenol novolac, such as "DC808" (manufactured by Mitsubishi Chemical Corp.); active ester type resins containing a benzoylated phenol novolac, such as "YLH1026" (manufactured by Mitsubishi Chemical Corp.); active ester type resins as the acetylated phenol novolac, such as "DC808" (manufactured by Mitsubishi Chemical Corp.); and active ester type resins as the benzoylated phenol novolac, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

As for the amine type resin, a resin having one or more, and preferably two or more, amino groups in one molecule may be used. Illustrative examples of the amine type resin may include an aliphatic amine compound, a polyether amine compound, an alicyclic amine compound, and an aromatic amine compound. Among them, an aromatic amine compound is preferable. The amine type resin is preferably a primary amine and a secondary amine; a primary amine is more preferable. Specific examples of the amine type resin may include 4,4'-methylenebis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylenediamine, m-xylylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof may include "KAYABOND C-200S", "KAYABOND C-100", "KAYAHARD A-A", "KAYAHARD A-B", and "KAYAHARD A-S", manufactured by Nippon Kayaku Co. Ltd., as well as "Epicure W" manufactured by Mitsubishi Chemical Corp.

As for the carbodiimide type resin, a resin having one or more, and preferably two or more, carbodiimide structures in one molecule may be used. Specific examples of the carbodiimide type resin may include a biscarbodiimide including an aliphatic biscarbodiimide such as tetramethylene-bis(t-butylcarbodiimide) and cyclohexane-bis(methylene-t-butylcarbodiimide), and an aromatic biscarbodiimide such as phenylene-bis(xylylcarbodiimide); and a polycarbodiimide including an aliphatic polycarbodiimide such as polyhexamethylene carbodiimide, polytrimethylhexamethylene carbodiimide, polycyclohexylene carbodiimide, poly(methylenebiscyclohexylene carbodiimide), and poly(isophorone carbodiimide), and an aromatic polycarbodiimide such as poly(phenylene carbodiimide), poly(naphthylene carbodiimide), poly(tolylene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylylene carbodiimide), poly(tetramethylxylylene carbodiimide), poly(methylenediphenylene carbodiimide), and poly[methylenebis(methylphenylene) carbodiimide]. Illustrative examples of the commercially available carbodiimide type resin may include "Carbodilite V-02B", "Carbodilite V-03", "Carbodilite V-04K", "Carbodilite V-07", and "Carbodilite V-09", manufactured by Nisshinbo Chemical Inc.; and "Stabaxol P", "Stabaxol P400", and "Hycasyl 510", manufactured by Rhein Chemie GmbH.

As for the acid anhydride type resin, a resin that has one or more acid anhydride groups in one molecule may be used, in which the resin having two or more acid anhydride groups in one molecule is preferable. Specific examples of the acid anhydride type resin may include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid. Illustrative examples of the commercially available product of the acid anhydride type resin may include "HNA-100", "MH-700", "MTA-15", "DDSA", and "OSA", manufactured by New Japan Chemical Co., Ltd.; "YH-306" and "YH-307", manufactured by Mitsubishi Chemical Corp.; "HN-2200" and "HN-5500", manufactured by Hitachi Chemical Co., Ltd.; and "EF-30", "EF-40", "EF-60", and "EF-80", manufactured by Cray Valley S.A.

Specific examples of the benzoxazine type resin may include "JBZ-OD100", "JBZ-OP100D", and "ODA-BOZ", manufactured by JFE Chemical Corp.; "P-d" and "F-a", manufactured by Shikoku Chemicals Corp.; and "HFB2006M" manufactured by Showa Highpolymer Co., Ltd.

Illustrative examples of the cyanate ester type resin may include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether; polyfunctional cyanate resins derived from a phenol novolac or a cresol novolac; and a prepolymer in which these cyanate resins partially form triazine. Specific examples of the cyanate ester type resin may include "PT30" and "PT60", (phenol novolac type polyfunctional cyanate ester resin); "ULL-950S" (polyfunctional cyanate ester resin); "BA230" and "BA230S75" (prepolymers in which part or all of bisphenol A dicyanate form triazine so as to be a trimer), manufactured all by Lonza Japan Ltd.

Illustrative examples of the thiol type resin may include trimethylolpropane tris(3-mercaptopropionate), pentaerythritol tetrakis(3-mercaptobutyrate), and tris(3-mercaptopropyl) isocyanurate.

The active group equivalent of (B-2) the curing agent is preferably in the range of 50 g/eq. to 3000 g/eq., more preferably in the range of 100 g/eq. to 1000 g/eq., still more preferably in the range of 100 g/eq. to 500 g/eq., and still more preferably in the range of 100 g/eq. to 300 g/eq. The active group equivalent is the mass of (B-2) the curing agent per one equivalent of the active group.

The number of the active groups in (B-2) the curing agent is preferably 0.01 or more, more preferably 0.1 or more, and still more preferably 0.5 or more, and is preferably 10 or less, more preferably 5 or less, and still more preferably 2 or less, relative to one epoxy group in (B-1) the epoxy resin. The active group in (B-2) the curing agent is, for example, an active hydroxy group; they are different depending on the curing agent. The number of the epoxy groups in (B-1) the epoxy resin is the total value obtained by dividing the mass of each epoxy resin with the epoxy equivalent and adding the divided values for all the epoxy resins. The number of the active groups in (B-2) the curing agent is the total value obtained by dividing the mass of each curing agent with the active group equivalent and adding the divided values for all the curing agents.

The range of the amount (% by mass) of (B-2) the curing agent included in the resin composition is preferably 0.1% by mass or more, more preferably 0.5% by mass or more, and still more preferably 1% by mass or more, and is preferably 15% by mass or less, more preferably 10% by mass or less, and still more preferably 5% by mass or less, relative to 100% by mass of the nonvolatile components in the resin composition.

The range of the amount (% by mass) of (B-2) the curing agent included in the resin composition is preferably 10% by mass or more, more preferably 20% by mass or more, and still more preferably 30% by mass or more, and is preferably 70% by mass or less, more preferably 60% by mass or less, and still more preferably 50% by mass or less, relative to 100% by mass of the resin components in the resin composition.

When (B) the thermosetting resin is classified by viscosity, (B) the thermosetting resin may contain a reactive diluent. The reactive diluent represents a component having a low viscosity in (B) the thermosetting resin. The specific viscosity of the reactive diluent is usually less than 0.5 Pa·s. There is no particular restriction with regard to the lower limit of the viscosity of the reactive diluent; the lower limit may be, for example, 0.001 Pa·s or more, 0.005 Pa·s or more, or 0.01 Pa·s or more. The viscosity of the reactive diluent may be measured using a Type E viscometer at 25 ± 2°C. When (B) the thermosetting resin contains the reactive diluent, the viscosity of the resin composition can be lowered, resulting in enhancement of an applicability of the liquid resin composition such as a magnetic paste and a magnetic ink.

The reactive diluent may contain a reactive group such as an epoxy group and an active group as described earlier. Illustrative examples of preferable reactive group contained in the reactive diluent may include an epoxy group, an acrylic group, a methacrylic group, and an oxetane group. Among these, an epoxy group is especially preferable. Therefore, it is preferable to use (B-1) the epoxy resin having a low viscosity as the reactive diluent.

Illustrative examples of the reactive diluent that is commercially available may include "EX-201" (cyclic aliphatic glycidyl ether), "EX-830" and "EX-821" (ethylene glycol type epoxy resin), "EX-212" (hexanediol type epoxy resin), and "ZX1658" and "ZX1658GS" (liquid 1,4-glycidylcyclohexane), manufactured by Nippon Steel Chemical & Material Co., Ltd.; "EP-3980S" (glycidylamine type epoxy resin), "EP-4088S" and "EP-4088L" (dicyclopentadiene type epoxy resin), and "ED-509S" (tert-butylphenyl glycidyl ether), manufactured by ADEKA Corp.; and "X-22-163" (siloxane type epoxy resin) manufactured by Shin-Etsu Chemical Co., Ltd. The reactive diluent may be used singly or in a combination of two or more of them.

The amount (% by mass) of the reactive diluent included in the resin composition is preferably 0.1% by mass or more, more preferably 0.5% by mass or more, and still more preferably 1% by mass or more, and is preferably 20% by mass or less, more preferably 10% by mass or less, and still more preferably 7% by mass or less, relative to 100% by mass of the nonvolatile components in the resin composition.

The amount (% by mass) of the reactive diluent included in the resin composition is preferably 5% by mass or more, more preferably 10% by mass or more, and still more preferably 20% by mass or more, and is preferably 80% by mass or less, more preferably 70% by mass or less, and still more preferably 60% by mass or less, relative to 100% by mass of the resin components in the resin composition.

The amount (% by mass) of the reactive diluent included in the resin composition is preferably 5% by mass or more, more preferably 10% by mass or more, and still more preferably 20% by mass or more, and is preferably 90% by mass or less, more preferably 80% by mass or less, and still more preferably 70% by mass or less, relative to 100% by mass of (B) the thermosetting resin.

The weight-average molecular weight (Mw) of (B) the thermosetting resin may usually be in the same range as that of the weight-average molecular weight of (B-1) the epoxy resin described above.

The range of the amount (% by mass) of (B) the thermosetting resin included in the resin composition is preferably 0.1% by mass or more, more preferably 1% by mass or more, and still more preferably 2% by mass or more, and is preferably 15% by mass or less, more preferably 13% by mass or less, and still more preferably 10% by mass or less, relative to 100% by mass of the nonvolatile components in the resin composition. When the amount of (B) the thermosetting resin is within the above-mentioned range, the magnetic layer having excellent magnetic properties can be obtained, and the electroplated layer can be formed on the surface of the magnetic layer by the electroplating without much problem.

The range of the amount (% by mass) of (B) the thermosetting resin included in the resin composition is preferably 40% by mass or more, more preferably 50% by mass or more, and still more preferably 60% by mass or more, and is preferably 98% by mass or less, more preferably 94% by mass or less, and still more preferably 90% by mass or less, relative to 100% by mass of the resin components in the resin composition. When the amount of (B) the thermosetting resin is within the above-mentioned range, the magnetic layer having excellent magnetic properties can be obtained, and the electroplated layer can be formed on the surface of the magnetic layer by the electroplating without much problem.

The range of the amount (% by mass) of (B) the thermosetting resin included in the resin composition is preferably 0.1% by mass or more, more preferably 1% by mass or more, and still more preferably 2% by mass or more, and is preferably 20% by mass or less, more preferably 16% by mass or less, and still more preferably 12% by mass or less, relative to 100% by mass of (A) the magnetic powder. When the amount of (B) the thermosetting resin is within the above-mentioned range, the magnetic layer having excellent magnetic properties can be obtained, and the electroplated layer can be formed on the surface of the magnetic layer by the electroplating without much problem.

### <(C) Curing accelerator>

The resin composition according to the present embodiment may further contain (C) a curing accelerator as the optional component in combination with the components (A) and (B) described above. (C) The curing accelerator as the component (C) does not include those that fall under the components (A) to (B) described above. (C) The curing accelerator functions as a catalyst to accelerate the curing reaction of (B) the thermosetting resin; thus, this can accelerate curing of the resin composition.

Illustrative examples of (C) the curing accelerator may include a phosphorous type curing accelerator, an amine type curing accelerator, an imidazole type curing accelerator, a guanidine type curing accelerator, and a metal type curing accelerator. Among these, an imidazole type curing accelerator is preferable. (C) The curing accelerator may be used singly or in a combination of two or more of them.

Illustrative examples of the imidazole type curing accelerator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin. Among these, 2-ethyl-4-methylimidazole and 1-benzyl-2-phenylimidazole are preferable. Commercially available products may be used as the imidazole type curing accelerator. Illustrative examples thereof may include "P200-H50" manufactured by Mitsubishi Chemical Corp.; and "Curezol 2MZ", "2E4MZ", "Cl1Z", "Cl1Z-CN", "Cl1Z-CNS", "Cl1Z-A", "2MZ-OK", "2MA-OK", "2MA-OK-PW", "2MZA-PW", "2PHZ", and "2PHZ-PW", manufactured by Shikoku Chemicals Corp.

Illustrative examples of the amine type curing accelerator may include: trialkylamines such as triethylamine and tributylamine; and 4-dimethylaminopyridine, benzyl dimethyl amine, 2,4,6-tris(dimethylaminomethyl)phenol, 1,8-diazabicyclo(5,4,0)-undecene, 1,8-diazabicyclo[5,4,0]undecene-7,4-dimethylaminopyridine, and 2,4,6-tris(dimethylaminomethyl)phenol. Among these, 4-dimethylaminopyridine is preferable.

Illustrative examples of the phosphorous type curing accelerator may include triphenyl phosphine, a phosphonium borate compound, tetraphenyl phosphonium tetraphenyl borate, n-butyl phosphonium tetraphenyl borate, tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and tetrabutyl phosphonium decanoate salt are preferable.

Illustrative examples of the guanidine type curing accelerator may include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the metal type curing accelerator may include organometallic complexes or organometallic salts of metals such as cobalt, copper, zinc, iron, nickel, manganese, and tin. Specific examples of the organometallic complex may include organic cobalt complexes such as cobalt (II) acetylacetonate and cobalt (III) acetylacetonate, organic copper complexes such as copper (II) acetylacetonate, organic zinc complexes such as zinc (II) acetylacetonate, organic iron complexes such as iron (III) acetylacetonate, organic nickel complexes such as nickel (II) acetylacetonate, and organic manganese complexes such as manganese (II) acetylacetonate. Illustrative examples of the organic metal salt may include zinc octylate, tin octylate, zinc naphthenate, cobalt naphthenate, tin stearate, and zinc stearate.

The amount (% by mass) of (C) the curing accelerator included in the resin composition may be 0% by mass, or more than 0% by mass, and is preferably 0.001% by mass or more, more preferably 0.01% by mass or more, and still more preferably 0.1% by mass or more, and is preferably 5% by mass or less, more preferably 3% by mass or less, and still more preferably 1% by mass or less, relative to 100% by mass of the nonvolatile components in the resin composition.

The amount (% by mass) of (C) the curing accelerator included in the resin composition may be 0% by mass, or more than 0% by mass, and is preferably 0.01% by mass or more, more preferably 0.1% by mass or more, and still more preferably 1% by mass or more, and is preferably 20% by mass or less, more preferably 15% by mass or less, and still more preferably 10% by mass or less, relative to 100% by mass of the resin components in the resin composition.

The amount (% by mass) of (C) the curing accelerator included in the resin composition may be 0% by mass, or more than 0% by mass, and is preferably 0.01% by mass or more, more preferably 0.1% by mass or more, and still more preferably 1% by mass or more, and is preferably 20% by mass or less, more preferably 15% by mass or less, and still more preferably 10% by mass or less, relative to 100% by mass of (B) the thermosetting resin.

### <(D) Thermoplastic resin>

The resin composition according to the present embodiment may further contain (D) a thermoplastic resin as the optional component in combination with the components (A) to (C) described above. (D) The thermoplastic resin as the component (D) does not include those that fall under the components (A) to (C) described above. (D) The thermoplastic resin may effectively enhance the mechanical properties of the magnetic layer.

Illustrative examples of (D) the thermoplastic resin may include a phenoxy resin, a polyimide resin, a polyvinyl acetal resin, a polyolefin resin, a polybutadiene resin, a polyamide imide resin, a polyether imide resin, a polysulfone resin, a polyether sulfone resin, a polyphenylene ether resin, a polycarbonate resin, a polyether ether ketone resin, and a polyester resin. (D) The thermoplastic resin may be used singly or in a combination of two or more of them.

Illustrative examples of the phenoxy resin may include those containing one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. Specific examples of the phenoxy resin may include "1256" and "4250" (both phenoxy resins containing a bisphenol A skeleton) manufactured by Mitsubishi Chemical Corp.; "YX8100" (phenoxy resin containing a bisphenol S skeleton) manufactured by Mitsubishi Chemical Corp.; "YX6954" (phenoxy resin containing a bisphenol acetophenone skeleton) manufactured by Mitsubishi Chemical Corp.; "FX280" and "FX293" manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482", and "YL7891BH30", all being manufactured by Mitsubishi Chemical Corp.

Specific examples of the polyimide resin may include "SLK-6100" manufactured by Shin-Etsu Chemical Co., Ltd., and "Rikacoat SN20" and "Rikacoat PN20", both being manufactured by New Japan Chemical Co., Ltd. Specific examples of the polyimide resin may include a linear polyimide (for example, polyimide described in Japanese Patent Application Laid-open No. 2006-37083) obtained by reacting a bifunctional hydroxyl group-terminated polybutadiene, a diisocyanate compound, and a tetrabasic acid anhydride, and modified polyimides such as the polyimides containing a polysiloxane skeleton (for example, polyimides described in Japanese Patent Application Laid-open No. 2002-12667 and Japanese Patent Application Laid-open No. 2000-319386).

Illustrative examples of the polyvinyl acetal resin may include a polyvinylformal resin and a polyvinyl butyral resin; here, the polyvinyl butyral resin is preferable. Specific examples of the polyvinyl acetal resin may include "Denka Butyral 4000-2", "Denka Butyral 5000-A", "Denka Butyral 6000-C", and "Denka Butyral 6000-EP", all of them being manufactured by Denka Company Limited; and the S-LEC BH series, the BX series (e.g., BX-5Z), the KS series (e.g., KS-1), the BL series, and the BM series, all of them being manufactured by Sekisui Chemical Co., Ltd.

Illustrative examples of the polyolefin resin may include low-density polyethylene, ultra-low-density polyethylene, high-density polyethylene, ethylene type copolymer resins such as an ethylene-vinyl acetate copolymer, an ethylene-ethyl acrylate copolymer, and an ethylene-methyl acrylate copolymer; and polyolefin polymers such as polypropylene and an ethylene-propylene block copolymer.

Illustrative examples of the polybutadiene resin may include a resin containing a hydrogenated polybutadiene skeleton, a polybutadiene resin containing a hydroxy group, a polybutadiene resin containing a phenolic hydroxyl group, a polybutadiene resin containing a carboxy group, a polybutadiene resin containing an acid anhydride group, a polybutadiene resin containing an epoxy group, a polybutadiene resin containing an isocyanate group, a polybutadiene resin containing a urethane group, and a polyphenylene ether-polybutadiene resin.

Specific examples of the polyamide imide resin may include "Vylomax HR11NN" and "Vylomax HR16NN", manufactured by Toyobo Co., Ltd. Specific examples of the polyamide imide resin may also include modified polyamide imides such as "KS9100" and "KS9300" (polyamide imide containing a polysiloxane skeleton) manufactured by Hitachi Chemical Co., Ltd.

Specifi examples of the polyether imide resin may include "Ultem" manufactured by GE.

Specific examples of the polysulfone resin may include polysulfone "P1700" and "P3500", both being manufactured by Solvay Advanced Polymers, Inc.

Specific examples of the polyethersulfone resin may include "PES5003P" manufactured by Sumitomo Chemical Co., Ltd.

Specific examples of the polyphenylene ether resin may include "NORYL SA90" manufactured by SABIC.

Illustrative examples of the polycarbonate resin may include a hydroxy group-containing carbonate resin, a phenolic hydroxy group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin may include "FPC0220" manufactured by Mitsubishi Gas Chemical Company, Inc., "T6002" and "T6001" (polycarbonate diol) manufactured by Asahi Kasei Chemicals; and "C-1090", "C-2090", and "C-3090" (polycarbonate diol) manufactured by Kuraray Co., Ltd.

Specific examples of the polyether ether ketone resin may include "Sumiploy K" manufactured by Sumitomo Chemical Co., Ltd.

Illustrative examples of the polyester resin may include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexanedimethyl terephthalate resin.

The weight-average molecular weight (Mw) of (D) the thermoplastic resin is preferably more than 5,000, more preferably 8,000 or more, still more preferably 10,000 or more, and still more preferably 20,000 or more. The upper limit thereof is not particularly restricted; the upper limit may be, for example, 1,000,000 or less, 500,000 or less, or 100,000 or less.

The amount (% by mass) of (D) the thermoplastic resin included in the resin composition may be 0% by mass, or more than 0% by mass, and is preferably 0.01% by mass or more, more preferably 0.05% by mass or more, and still more preferably 0.1% by mass or more, and is preferably 5% by mass or less, more preferably 3% by mass or less, and still more preferably 1% by mass or less, relative to 100% by mass of the nonvolatile components in the resin composition.

The amount (% by mass) of (D) the thermoplastic resin included in the resin composition may be 0% by mass, or more than 0% by mass, and is preferably 1% by mass or more, more preferably 5% by mass or more, and still more preferably 10% by mass or more, and is preferably 30% by mass or less, more preferably 20% by mass or less, and still more preferably 15% by mass or less, relative to 100% by mass of the resin components in the resin composition.

The amount (% by mass) of (D) the thermoplastic resin included in the resin composition may be 0% by mass, or more than 0% by mass, and is preferably 0.01% by mass or more, more preferably 0.05% by mass or more, and still more preferably 0.1% by mass or more, and is preferably 5% by mass or less, more preferably 3% by mass or less, and still more preferably 1% by mass or less, relative to 100% by mass of (A) the magnetic powder.

### <(E) Dispersant>

The resin composition according to the present embodiment may further contain (E) a dispersant as the optional component in combination with the components (A) to (D) described above. (E) The dispersant as the component (E) does not include those that fall under the components (A) to (D) described above. When using (E) the dispersant, it is possible to effectively enhance the dispersibility of (A) the magnetic powder.

As for (E) the dispersant, a compound that is capable of lowering the viscosity of the resin composition may be used. Illustrative examples of (E) the dispersant may include a phosphate ester type dispersant, a polyoxyalkylene type dispersant, an acetylene type dispersant, a silicone type dispersant, an anionic dispersant, and a cationic dispersant. (E) The dispersant may be used singly or in a combination of two or more of them. Among these, the phosphate ester type dispersant is preferable.

Among the phosphate ester type dispersants, a polyether phosphate ester type dispersant is preferable. The polyether phosphate ester type dispersant is the phosphate ester type dispersant containing a poly(alkyleneoxy) structure in the molecule. Illustrative examples of the polyether phosphate ester type dispersant may include a polyoxyalkylene alkyl ether phosphate ester and a polyoxyalkylene alkyl phenyl ether phosphate ester. Among these, the polyoxyalkylene alkyl ether phosphate ester is preferable.

The polyoxyalkylene alkyl ether phosphate ester may have a structure in which one to three alkyl-oxy-poly(alkyleneoxy) groups are bonded to the phosphorous atom of the phosphate salt. The number of alkyleneoxy units (number of repeating units) of the poly(alkyleneoxy) moiety in the alkyl-oxy-poly(alkyleneoxy) group is preferably 2 to 30, and more preferably 3 to 20. The alkylene group in the poly(alkyleneoxy) moiety is preferably an alkylene group having 2 to 4 carbon atoms. Illustrative examples of the alkylene group may include an ethylene group, a propylene group, an isopropylene group, a butylene group, and an isobutyl group. Furthermore, the alkyl group in the alkyl-oxy-poly(alkyleneoxy) group is preferably an alkyl group having 6 to 30 carbon atoms, and more preferably an alkyl group having 8 to 20 carbon atoms. Illustrative examples of the alkyl group may include a decyl group, an undecyl group, a dodecyl group, a tridecyl group, a tetradecyl group, a pentadecyl group, a hexadecyl group, a heptadecyl group, and an octadecyl group. When the polyoxyalkylene alkyl ether phosphate ester has a plurality of alkyl-oxy-poly(alkyleneoxy) groups, a plurality of alkyl groups may be the same or different. Furthermore, a plurality of alkylene groups may be the same or different.

Illustrative examples of the commercially available phosphate ester type dispersant may include polyether phosphate ester type dispersants (e.g., "ED152", "ED153", "ED154", "ED118", "ED174", and "ED251" of the HIPLAAD series), all being manufactured by Kusumoto Chemicals, Ltd.; and "RS-410", "RS-610", and "RS-710" of the Phosphanol series manufactured by Toho Chemical Industry Co., Ltd.

Illustrative examples of the polyoxyalkylene type dispersant may include a polyoxyethylene alkyl ether, a polyoxyethylene alkyl ester, a polyoxyethylene sorbitan fatty acid ester, a polyoxyethylene alkyl phenyl ether, a polyoxyethylene alkylamine, and a polyoxyethylene alkylamide. Illustrative examples of the commercially available polyoxyalkylene type dispersant may include "AKM-0531", "AFB-1521", "SC-0505K", "SC-1015F", "SC-0708A", and "HKM-50A" of the "Malialim" series manufactured by NOF Corp.

Illustrative examples of the acetylene type dispersant may include acetylene glycol. Illustrative examples of the commercially available acetylene type dispersant may include "82", "104", "440", "465", "485", and "Olefin Y" of the "Surfynol" series manufactured by Air Products and Chemicals Inc.

Illustrative examples of the silicone type dispersant may include polyether-modified polydimethylsiloxane, polyether-modified siloxane, and polyester-modified polydimethylsiloxane. Illustrative examples of the commercially available silicone type dispersant may include "BYK 347" and "BYK 348", both being manufactured by BYK Chemie GmbH.

Illustrative examples of the anionic dispersant may include sodium polyacrylate, sodium dodecylbenzyl sulfonate, sodium laurylate, ammonium polyoxyethylene alkyl ether sulfate, and sodium carboxymethyl cellulose salt. Illustrative examples of the commercially available anionic dispersant may include "PN-411" and "PA-111", both being be manufactured by Ajinomoto Fine-Techno Co., Inc.; and "A-550" and "PS-1900", both being manufactured by Lion Corp.

Illustrative examples of the cationic dispersant may include a polyacrylate type resin containing an amino group and a polystyrene type resin containing an amino group. Illustrative examples of the commercially available cationic dispersant may include "161", "162", "164", "182", "2000", and "2001", all being manufactured by BYK Chemie GmbH; "PB-821", "PB-822", and "PB -824", all being manufactured by Ajinomoto Fine-Techno Co., Inc.; "V-216" and "V-220", both being manufactured by ISP Japan, Ltd.; and "Solsperse 13940", "Solsperse 24000", and "Solsperse 32000", all being manufactured by Lubrizol, Inc.

(E) The dispersant may be used singly or in a combination of two or more of them.

The amount (% by mass) of (E) the dispersant included in the resin composition may be 0% by mass, or more than 0% by mass, and is preferably 0.01% by mass or more, more preferably 0.05% by mass or more, and still more preferably 0.1% by mass or more, and is preferably 5% by mass or less, more preferably 3% by mass or less, and still more preferably 1% by mass or less, relative to 100% by mass of the nonvolatile components in the resin composition.

The amount (% by mass) of (E) the dispersant included in the resin composition may be 0% by mass, or more than 0% by mass, and is preferably 0.1% by mass or more, more preferably 1% by mass or more, and still more preferably 5% by mass or more, and is preferably 30% by mass or less, more preferably 20% by mass or less, and still more preferably 15% by mass or less, relative to 100% by mass of the resin components in the resin composition.

The amount (% by mass) of (E) the dispersant included in the resin composition may be 0% by mass, or more than 0% by mass, and is preferably 0.01% by mass or more, more preferably 0.05% by mass or more, and still more preferably 0.1% by mass or more, and is preferably 5% by mass or less, more preferably 3% by mass or less, and still more preferably 1% by mass or less, relative to 100% by mass of (A) the magnetic powder.

### <(F) Optional additive>

The resin composition according to the present embodiment may further contain (F) an optional additive as the optional component in combination with the components (A) to (E) described above. (F) The optional additive as the component (F) does not include those that fall under the components (A) to (E) described above.

Illustrative examples of (F) the optional additive may include: inorganic fillers such as a silica particle; organic fillers such as a rubber particle; organometallic compounds such as an organocopper compound and an organozinc compound; radical polymerization initiators such as a peroxide type radical polymerization initiator and an azo type radical polymerization initiator; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. (F) The optional additive may be used singly or in a combination of two or more of them.

### <(G) Solvent>

The resin composition may further contain (G) a solvent as the volatile component in combination with the nonvolatile components such as the components (A) to (F) described above. An organic solvent is usually used as (G) the solvent. Illustrative examples of the organic solvent may include: ketone type solvents such as acetone, methyl ethyl ketone (MEK), methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, butylcarbitol acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. (G) The solvent may be used singly or in a combination of two or more of them.

### <Production method of the resin composition>

The resin composition according to the present embodiment can be produced, for example, by mixing the above-mentioned components. These components may be mixed in part or in whole at the same time or in sequence. In the course of mixing of each component, the temperature may be set as appropriate; therefore, temporarily or throughout the entire process, heating and/or cooling may be carried out. In addition, in the course of mixing of each component, stirring or shaking may be carried out.

### <Characteristics of the resin composition>

The resin composition according to the present embodiment can be cured by heat. Therefore, by thermally curing the resin composition, a cured product of the resin composition can be obtained. Normally, among the components included in the resin composition, volatile components such as (G) the solvent may be volatilized by heat during thermal curing, while non-volatile components such as the components (A) to (F) are not volatilized by heat during thermal curing. Therefore, the cured product of the resin composition may contain non-volatile components of the resin composition or reaction products thereof. The cured product of the resin composition can be superior in magnetic properties such as a relative magnetic permeability and a magnetic loss. Accordingly, this cured product can be used as the material for the magnetic layer of the magnetic substrate.

Usually, the cured product of the resin composition according to the present embodiment can have a high relative magnetic permeability µ'. Specifically, the range of the relative magnetic permeability µ' of the cured product is preferably 10 or more, more preferably 12 or more, and still more preferably 15 or more. The upper limit of the relative magnetic permeability µ' is not particularly restricted; the upper limit may be, for example, 35 or less, 30 or less, or 25 or less. In the production method of the magnetic substrate according to the present embodiment, when the resin composition containing (A) the magnetic powder in an amount sufficient to achieve the above-mentioned range of the relative magnetic permeability is used, the electroplated layer can be formed by the electroplating on the surface of the magnetic layer containing the cured product of the resin composition without much problem. The relative magnetic permeability µ' of the cured product can be measured at the measurement frequency of 20 MHz and at the room temperature of 23°C. When the resin composition is cured for the measurement of the relative magnetic permeability µ', the cured product as a measurment sample can be obtained by thermally curing the resin composition under the conditions of 190°C for 90 minutes. As the specific measurement method of the relative magnetic permeability µ', the method to be described later in [Examples] may be employed.

The cured product of the resin composition according to the present embodiment can usually have a low magnetic loss. The magnetic loss may be expressed by the magnetic loss tangent tanδ. Generally, the smaller the magnetic loss tangent tanδ is, the smaller the magnetic loss is. Specifically, the range of the magnetic loss tangent tanδ of the cured product is preferably 0.05 or less, more preferably 0.04 or less, and still more preferably 0.03 or less. There is no particular restriction with regard to the lower limit of the magnetic loss tangent tanδ; and the lower limit may be, for example, 0.001 or more. In the production method of the magnetic substrate according to the present embodiment, when the resin composition containing (A) the magnetic powder in an amount sufficient to achieve the above-mentioned range of the magnetic loss is used, the electroplated layer can be formed by the electroplating on the surface of the magnetic layer containing the cured product of the resin composition without much problem. The magnetic loss tangent tanδ of the cured product can be measured at the measurement frequency of 20 MHz and at a room temperature of 23°C. When the resin composition is cured for the measurement of the magnetic loss tangent tanδ, the cured product as a measurment sample can be obtained by thermally curing the resin composition under the conditions of 190°C for 90 minutes. As the specific measurment method of the magnetic loss tangent tanδ, the method to be described later in [Examples] may be employed.

The cured product of the resin composition according to the present embodiment can usually have a high volume resistance. Therefore, according to the cured product, the magnetic layer having an insulating property can be formed. Specifically, the range of the volume resistance of the cured product is preferably 1.0 × 10⁸ Ω·m or more, more preferably 5.0 × 10⁸ Ω·m or more, and still more preferably 1.0 × 10⁹ Ω·m or more, and is preferably 1.0 × 10¹³ Ω·m or less, more preferably 5.0 × 10¹² Ω·m or less, and still more preferably 1.0 × 10¹² Ω·m or less. It is surprising from the technical common sense of those skilled in the art that it is possible to form the electroplated layer by the electroplating on the surface of the magnetic layer formed of a cured product having such a high volume resistance. As the measurment method of the volume resistance of the cured product, the method to be described later in [Examples] may be employed.

There is no particular restriction with regard to the form of the resin composition. Therefore, the resin composition may be in a liquid form having fluidity. For example, the resin composition may be a liquid resin composition without containing (G) the solvent or a liquid resin composition with containing (G) the solvent. Hereinafter, the liquid resin composition without containing (G) the solvent may be referred to as "magnetic paste". The liquid resin composition with containing (G) the solvent may be referred to as "magnetic ink".

The liquid resin composition such as the magnetic paste and the magnetic ink has fluidity; thus, it may be suitably used to form the magnetic layer by means of a printing method. The liquid resin composition is preferably in a liquid form at 23°C. The viscosity of the liquid resin composition at 23°C is preferably 20 Pa·s or more, more preferably 25 Pa·s or more, still more preferably 30 Pa·s or more, and especially preferably 50 Pa·s or more, and is preferably 200 Pa·s or less, more preferably 180 Pa·s or less, and still more preferably 160 Pa·s or less. The viscosity can be measured, for example, using an E-type viscometer ("RE-80U" manufactured by Toki Sangyo Co., Ltd., 3° × R9.7 rotor) under the measurment conditions of the sample volume of 0.22 ml and the rotation speed of 5 rpm.

The resin composition may be in a solid form. There is no particular restriction with regard to the form of the solid resin composition, which may be, for example, in the form of a particle, of a pellet, or of a film. Among them, the film form is preferable because it is possible to form the magnetic layer by a lamination method. The resin composition in the form of film is usually prepared as a resin sheet having a resin composition layer as the film of the resin composition.

The resin composition layer contains the resin composition, and preferably contains only the resin composition. The thickness of the resin composition layer may be determined according to the size of the magnetic substrate to be produced. Usually, it is preferable that the resin composition layer is thin. Specifically, the range of the thickness of the resin composition layer is preferably 5 µm or more, more preferably 10 µm or more, and still more preferably 50 µm or more, and is preferably 600 µm or less, more preferably 300 µm or less, still more preferably 200 µm or less, and further still more preferably 150 µm or less.

The resin sheet may further include an optional member in combination with the resin composition layer. For example, the resin sheet may include a support that supports the resin composition layer. In the resin sheet including the support, the resin composition layer is usually formed on the support.

Illustrative examples of the support may include a film formed of a plastic material, metal foil, and a releasing paper, in which the film formed of a plastic material and the metal foil are preferable.

In the case that the film formed of a plastic material is used as the support, illustrative examples of the plastic material may include: polyesters such as polyethylene terephthalate (hereinafter, this may be simply called "PET") and polyethylene naphthalate (hereinafter, this may be simply called "PEN"); polycarbonate (hereinafter, this may be simply called "PC"); acryl polymers such as polymethyl methacrylate (PMMA); a cyclic polyolefin; triacetyl cellulose (TAC); polyether sulfide (PES); polyether ketone; and polyimide. Among these, polyethylene terephthalate and polyethylene naphthalate are preferable; an inexpensive polyethylene terephthalate is especially preferable.

In the case that metal foil is used as the support, illustrative examples of the metal foil may include copper foil and aluminum foil; copper foil is preferable. As for the copper foil, the foil formed of a copper single metal may be used. The foil formed of an alloy of copper with other metal (for example, tin, chromium, silver, magnesium, nickel, zirconium, silicon, and titanium) may also be used.

The support may have been subjected to a treatment such as a mat treatment, a corona treatment, and an antistatic treatment, on the surface to be bonded with the resin composition layer.

As for the support, a releasing layer-attached support having a releasing layer on the surface to be bonded with the resin composition layer may be used. The releasing agent to be used in the releasing layer of the releasing layer-attached support may be one or more releasing agents selected from the group consisting of, for example, an alkyd type releasing agent, a polyolefin type releasing agent, a urethane type releasing agent, and a silicone type releasing agent. As for the releasing layer-attached support, a commercially available product may be used. Illustrative examples thereof may include "PET501010", "SK-1", "AL-5", and "AL-7", all being manufactured by Lintec Inc.; "Lumirror T60" manufactured by Toray Industries, Inc.; "PUREX" manufactured by Teijin Limited; and "UNIPEEL" manufactured by Unitika, Ltd., all of which are PET films having the releasing layer composed of mainly a silicone type releasing agent or an alkyd resin type releasing agent.

There is no particular restriction with regard to the thickness of the support; the thickness is preferably 1 µm or more, more preferably 5 µm or more, and still more preferably 10 µm or more, and is preferably 75 µm or less, more preferably 60 µm or less, and still more preferably 50 µm or less. When the releasing layer-attached support is used, it is preferable that the thickness of the entire releasing layer-attached support is within the above-mentioned range.

The resin sheet may include a protective film to protect the resin composition layer, as needed. The protective film is usually formed on the surface of the resin composition layer not being bonded to the support (namely, on the surface opposite with repsect to the support). The thickness of the protective film is not particularly restricted; the thickness is, for example, 1 µm to 40 µm. When the protective film is formed, the surface of the resin composition layer can be prevented from attachment of dirt and formation of a scar. When the resin sheet including the protective film is used, the protective film is usually removed before the step (LF).

The resin sheet may be produced, for example, by the method that includes forming the resin composition layer on the support. The resin composition layer may be formed, for example, after the resin composition is prepared, by the method that includes applying this resin composition onto the support. If necessary, the resin composition may be mixed with an organic solvent before applying onto the support. When an organic solvent is used, drying may be performed after application, as needed.

The application of the resin composition may be performed using coating equipment such as a die coater. Drying may be carried out, for example, by a drying method such as heating or blowing a hot air. The drying condition is not particularly restricted. Drying is carried out in such a way as to bring the content of the solvent in the resin composition layer preferably to 10% by mass or less, and more preferably to 5% by mass or less. Drying may be performed, for example, under the conditions of 50°C to 150°C and 3 minutes to 10 minutes, although these conditions may vary depending on the boiling point of the solvent.

### [Step (LF): Formation of the resin composition layer]

The production method of the magnetic substrate according to the present embodiment may include, before the step (EP), a step (LF) of forming the resin composition layer. At the step (LF), usually the resin composition layer is formed on a suitable substrate. Hereinafter, this substrate may be referred to as "inner layer substrate".

For example, a member including a supporting substrate may be used as the inner layer substrate. Illustrative examples of the supporting substrate may include insulating substrates such as a glass epoxy substrate, a metal substrate, a polyester substrate, a polyimide substrate, a BT resin substrate, and a thermosetting type polyphenylene ether substrate. The inner layer substrate may be provided with a conductor layer such as a wiring layer and an electrode layer, as needed. In the following description, the conductor layer that is included in the inner layer substrate may be referred to as "substrate conductor layer". The substrate conductor layer may be formed on one surface of the supporting substrate, or on both surfaces of the supporting substrate, or inside the supporting substrate. As for the substrate conductor layer, a layer formed of a metal such as copper may be mentioned. The inner layer substrate may have a hole formed therein such as a through hole, as needed. Hereinafter, the hole formed in the inner layer substrate may be referred to as "first hole". The first hole may be formed by a processing method such as a drilling, a laser irradiation, or a plasma irradiation. If necessary, the substrate conductor layer may be formed on the surface of the inner layer substrate in the first hole.

There are no particular restriction with regard to the method of forming the resin composition layer on the inner layer substrate. For example, when a liquid resin composition is used, the resin composition layer may be formed by applying the resin composition onto the inner layer substrate. To illustrate a specific example thereof, the resin composition layer may be formed by applying the resin composition onto the inner layer substrate using an applicator such as a dispenser and a die coater. The resin composition layer may also be formed by applying the resin composition layer onto the inner layer substrate by a printing method such as a full-area printing or a pattern printing. Illustrative examples of the printing method may include a method in which the resin composition is printed via a squeegee, a method in which the resin composition is printed via a cartridge, a method in which the resin composition is printed by a mask printing method, a roll coating method, and an inkjet method. In addition, drying may be performed after the application of the resin composition, as needed.

For example, in the case when the resin sheet including the resin composition layer is used, the resin composition layer may be formed on the inner layer substrate by laminating the resin sheet and the inner layer substrate such that the resin composition layer is bonded to the inner layer substrate. Bonding of the resin composition layer to the inner layer substrate can be performed, for example, by a hot-press bonding of the resin sheet to the inner layer substrate from the side of the support. Illustrative examples of the member used for the hot-press bonding of the resin sheet to the inner layer substrate (hereinafter, this may be referred to as "hot-press bonding member") may include a heated metal plate (such as a stainless (SUS) mirror plate) or a heated metal roll (such as a SUS roll). Here, it is preferable that the hot-press bonding member is not pressed in direct contact with the resin sheet but pressed via a sheet or the like formed of an elastic material such as a heat-resistant rubber in such a way that the resin sheet can well follow the irregularity on the surface of the inner layer substrate.

The temperature at the time of the hot-press bonding is preferably in the range of 80°C to 160°C, more preferably in the range of 90°C to 140°C, and still more preferably 100°C to 120°C. The pressure at the time of the hot-press bonding is preferably in the range of 0.098 MPa to 1.77 MPa, and more preferably in the range of 0.29 MPa to 1.47 MPa. The period at the time of the hot-press bonding is preferably in the range of 20 seconds to 400 seconds, and more preferably in the range of 30 seconds to 300 seconds. It is preferable that the bonding of the resin sheet to the inner layer substrate is conducted under the reduced pressure condition of 26.7 hPa or less.

Bonding of the resin composition layer of the resin sheet to the inner layer substrate may be performed by a commercially available vacuum laminator. Illustrative examples of the commercially available vacuum laminator may include a vacuum pressing laminator manufactured by Meiki Co., Ltd. and a vacuum applicator manufactured by Nikko-Materials Co., Ltd.

After the bonding between the resin sheet and the inner layer substrate, the laminated resin sheet may be subjected to a flattening treatment, for example, by pressing the hot-press bonding member from the side of the support under a normal pressure (under an atmospheric pressure). The pressing conditions of the flattening treatment may be the same as the hot-press bonding conditions in the aforementioned lamination. The flattening treatment can be performed using a commercially available laminator. The lamination and the flattening treatments may be performed continuously by using the aforementioned commercially available vacuum laminator.

In the case where the resin sheet including the support is used, the support is usually removed after the step (LF). The removal of the support may be performed before the step (CU) or after the step (CU), and it is preferable to perform before the step (EP).

In the case where the first hole is formed in the inner layer substrate, the step (LF) may include forming of the resin composition layer in the first hole. Usually, the resin composition layer is formed by filling the resin composition into the first hole. For example, the formation of the resin composition layer in the first hole may be performed by applying the resin composition in the form of liquid onto the inner layer substrate having the first hole formed therein to fill the first hole with the resin composition. For example, the formation of the resin composition layer in the first hole may be performed by laminating the inner layer substrate having the first hole formed therein with the resin sheet to fill the first hole with the resin composition.

### [Step (CU): Curing of the resin composition layer]

The production method of the magnetic substrate according to the present embodiment may include, after the step (LF), a step (CU) of curing the resin composition layer to form the magnetic layer. The magnetic layer is formed usually by thermally curing the resin composition layer under particular thermal curing conditions. This magnetic layer includes the cured product of the resin composition, and preferably includes only the cured product of the resin composition.

The conditions of the thermal curing of the resin composition layer may be determined as appropriate as long as the curing of the resin composition proceeds. The curing temperature is preferably 120°C or higher, more preferably 130°C or higher, and still more preferably 150°C or higher, and is preferably 245°C or lower, more preferably 220°C or lower, and still more preferably 200°C or lower. The curing time is preferably 5 minutes or longer, more preferably 10 minutes or longer, and still more preferably 15 minutes or longer, and is preferably 120 minutes or shorter, more preferably 110 minutes or shorter, and still more preferably 100 minutes or shorter.

The production method of the magnetic substrate according to the present embodiment may include, after the resin composition layer is formed and before the resin composition layer is cured, a step (preliminary heating step) of heating the resin composition layer at the temperature lower than the curing temperature thereof. For example, prior to curing the resin composition layer, the resin composition layer may be preliminarily heated at a temperature of usually 50°C or higher and lower than 150°C (preferably 60°C or higher and 140°C or lower, more preferably 70°C or higher and 130°C or lower), usually for 5 minutes or longer (preferably in the range of 5 minutes to 150 minutes, more preferably in the range of 15 minutes to 120 minutes).

### [Step (PO): polishing]

The production method of the magnetic substrate according to the present embodiment may include, before the step (EP), a step (PO) of polishing the resin composition layer or the magnetic layer. By performing the polishing, the surface of the magnetic layer can be smoothened. For example, when the magnetic layer is polished, the surface of the polished magnetic layer can be flattened. When the resin composition layer is polished, the surface of the resin composition layer can be flattened, so that the surface of the magnetic layer obtained by curing the resin composition layer can be flattened. In particular, when the first hole in the inner layer substrate is filled with the resin composition to form the resin composition layer, an excessive amount of the resin composition protrudes from the first hole or adheres to some part of the inner layer substrate other than the first hole, forming an irregular surface on the resin composition layer. Therefore, from the viewpoint of improving the flatness of the surface of the magnetic layer by removing the aforementioned irregularities through polishing, it is preferable to carry out the step (PO) in the case where the inner layer substrate having the first hole formed therein is used.

Illustrative examples of the polishing method may include a buff polishing method, a belt polishing method, and a ceramic polishing method. Illustrative examples of the buff polishing equipment that is commercially available may include "NT-700IM" manufactured by Ishiihyoki Co., Ltd.

From the viewpoint of enhancing the adhesion with the electroplated layer, the arithmetic average roughness (Ra) of the polished surface of the magnetic layer (after thermal curing of the cured product layer) is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) can be measured, for example, by using a non-contact type surface roughness meter.

In the case where the polishing is carried out after the magnetic layer is formed by curing the resin composition layer, the magnetic layer may be subjected to a heat treatment before the polishing in order to further increase the curing degree of the cured product included in the magnetic layer. As for the temperature at this heat treatment, the aforementioned curing temperature may be applied. Specifically, the heat treatment temperature is preferably 120°C or higher, more preferably 130°C or higher, and still more preferably 150°C or higher, and is preferably 245°C or lower, more preferably 220°C or lower, and still more preferably 200°C or lower. The heat treatment time is preferably 5 minutes or longer, more preferably 10 minutes or longer, and still more preferably 15 minutes or longer, and is preferably 90 minutes or shorter, more preferably 70 minutes or shorter, and still more preferably 60 minutes or shorter.

On the other hand, in the case where polishing is carried out before forming the magnetic layer by curing the resin composition layer, a preliminary heating treatment may be performed to heat the resin composition layer at a temperature lower than the curing temperature of the resin composition before the polishing. The temperature at the preliminary heating treatment is preferably 100°C or higher, more preferably 110°C or higher, and still more preferably 120°C or higher, and is preferably 245°C or lower, more preferably 220°C or lower, and still more preferably 200°C or lower. The heating treatment time is preferably 5 minutes or longer, more preferably 10 minutes or longer, and still more preferably 15 minutes or longer, and is preferably 90 minutes or shorter, more preferably 70 minutes or shorter, and still more preferably 60 minutes or shorter.

### [Step (HF): formation of second hole]

The production method of the magnetic substrate according to the present embodiment may include, before the step (EP), a step (HF) of forming a hole in the magnetic layer. Hereinafter, the hole formed in the magnetic layer may be referred to as "second hole". Usually, the formation of the second hole is carried out after the step (CU). The formation of the second hole may be performed before polishing at the step (PO), but is usually performed after the polishing at the step (PO).

The second hole may include, for example, a via hole and a through hole. For example, in the case where the second hole is formed in the magnetic layer that is formed in the first hole of the inner layer substrate, the second hole may be a through hole that penetrates through the magnetic layer. For example, in the case where the second hole is formed in the magnetic layer that is formed on the main surface of the inner layer substrate, the second hole may be a via hole that penetrates through the magnetic layer but does not penetrate through the inner layer substrate, or may be a through hole that penetrates through both the magnetic layer and the inner layer substrate. The second hole may be formed by the processing method such as a drilling, a laser processing, a plasma irradiation, or an etching.

### [Step (RO): roughening treatment]

The production method of the magnetic substrate according to the present embodiment may include a step (RO) of subjecting the magnetic layer to a roughening treatment before the step (EP). The roughening treatment is usually performed after the step (PO). The roughening treatment is usually performed after the step (HF). The roughening treatment causes the surface roughness of the magnetic layer to be increased thereby enhancing the adhesion strength between the magnetic layer and the electroplated layer. By the roughening treatment, a resin residue (smear) that may be formed during the formation of the second hole can be removed. The roughening treatment may be performed by a wet process, but a dry process is preferable. As for the dry roughening treatment, for example, a plasma treatment may be mentioned.

### [Step (EP): electroplating]

The production method of the magnetic substrate according to the present embodiment includes a step (EP) of forming the electroplated layer as the conductor layer on the surface of the magnetic layer by the electroplating. In the electroplating, the electroplated layer is formed on the surface of the magnetic layer usually in a plating solution that is a solution containing a metal ion. For example, the magnetic layer and an electrode are placed in a plating solution, and a direct current is applied between the magnetic layer and the electrode from a power source. The metal ion is reduced on the surface of the magnetic layer, and the resulting metal is deposited to form the electroplated layer containing the metal. As for the metal to be used for the electroplating, copper is preferable.

Usually, an aqueous solution of a metal salt is used as the plating solution. There is no restriction with regard to the metal salt as long as the electroplated layer can be formed. For example, when copper is used as the metal, illustrative examples of the copper salt may include copper sulfate such as copper sulfate pentahydrate, copper halide such as copper chloride, copper acetate, copper nitrate, copper tetrafluoroborate, copper alkylsulfonate, copper arylsulfonate, copper sulfamate, copper perchlorate, and copper gluconate. Among them, copper sulfate is preferable. The concentration of the metal salt in the plating solution may be, for example, 50 g/L or more and 400 g/L or less. The concentration of the metal salt in the plating solution is more preferably a saturate concentration.

It is preferable that the plating solution contains an acid. Illustrative examples of the acid may include sulfuric acid; hydrochloric acid; acetic acid; nitric acid; phosphoric acid; fluoroboric acid; alkanesulfonic acids such as methanesulfonic acid, ethanesulfonic acid, propanesulfonic acid, and trifluoromethanesulfonic acid; arylsulfonic acids such as benzenesulfonic acid, p-toluenesulfonic acid, and sulfamic acid; hydrobromic acid; perchloric acid; and chromic acid. Among these, sulfuric acid, methanesulfonic acid, ethanesulfonic acid, propanesulfonic acid, hydrochloric acid, and a combination of these acids are preferable; sulfuric acid is more preferable. The concentration of the acid in the plating solution may be, for example, 1 mL/L or more and 400 mL/L or less. In particular, when sulfuric acid is used, the concentration of sulfuric acid is preferably 40 mL/L or more, and preferably 200 mL/L or less.

The plating solution may contain an additive. Examples of the additive that the plating solution may contain may include a halide ion provider, a brightening agent, and a surfactant. Illustrative examples of the halide ion provider may include chloride compounds such as sodium chloride and potassium chloride. The concentration of the halide ion provider in the plating solution may be, for example, 0.5 mg/L or more and 300 mg/L or less. Examples of the brightening agent may include organosulfur compounds such as bis(3-sulfopropyl) disulfide salt. The concentration of the brightening agent in the plating solution may be, for example, 0.1 ppm or more and 1000 ppm or less. Illustrative examples of the surfactant may include an anionic surfactant, a cationic surfactant, and a nonionic surfactant. The concentration of the surfactant in the plating solution may be, for example, 1 mL/L or more and 60 mL/L or less.

The temperature of the plating solution is not restricted as long as the electroplated layer can be formed; and the temperature is preferably 2°C or higher, more preferably 10°C or higher, and still more preferably 15°C or higher, and is preferably 80°C or lower, more preferably 50°C or lower, and still more preferably 30°C or lower.

The current density of the current applied during the electroplating is not restricted as long as the electroplated layer can be formed; and the current density is preferably 0.5 A/dm² or more, more preferably 1.0 A/dm² or more, and is preferably 8.0 A/dm² or less, and more preferably 7.0 A/dm² or less.

The electroplating may be performed with flowing the plating solution. The flowing speed of the plating solution may be, for example, 3 cm/sec or more and 200 cm/sec or less.

According to the electroplating described above, the electroplated layer can be formed directly on the surface of the magnetic layer. The term "directly" used in the formation of the electroplated layer on the surface of the magnetic layer means that there is no other layer between the magnetic layer and the electroplated layer, and thereby the magnetic layer and the electroplated layer are in contact with each other. There is an interface formed between the magnetic layer and the electroplated layer that are in contact with each other, but usually there is no plating catalyst at the interface. In the case when a conductor layer is formed on a magnetic layer by the electroless plating, a plating catalyst such as palladium, gold, silver, or platinum remains between the magnetic layer and the conductor layer. Therefore, the electroplated layer can be distinguished from the conductor layer formed by the electroless plating with the existence of the plating catalyst.

According to the electroplating described above, it is possible to form the electroplated layer without forming a thin conductor layer (seed layer) by the electroless plating. Therefore, the electroless plating can be omitted, and it is possible to reduce the number of the steps in the production method of the magnetic substrate. From the viewpoint of effectively utilizing this advantage, it is preferable that, between the step (CU) of curing the resin composition layer to form the magnetic layer and the step (EP) of forming the electroplated layer on the surface of the magnetic layer, the production method of the magnetic substrate according to the present embodiment does not include the step of forming the conductor layer on the surface of the magnetic layer by a method other than the electroplating.

When the electroless plating is not performed as described above, no chemical solution for the electroless plating is required; thus, there is no need to control the composition of the chemical solution. Accordingly, the production time of the magnetic substrate can be shortened and the labor related to this can become less cumbersome. A certain chemical solution may dissolve or deteriorate the alloy; but according to the production method not using the chemical solution, (A-1) the alloy powder that may be dissolved or deteriorated by the chemical solution can be used. Accordingly, the selection range of (A-1) the alloy powder can be expanded; thus, diversification and sophistication of the magnetic substrate can be expected.

In the case where the second hole is formed in the magnetic layer, the step (EP) of forming the electroplated layer may include forming the electroplated layer by the electroplating on the surface in the second hole of the magnetic layer. From the viewpoint of promoting the formation of the electroplated layer in the second hole, it is preferable to perform the electroplating with flowing the plating solution so that the plating solution can easily enter the second hole. From the viewpoint of further increase the efficiency in formation of the electroplated layer in the second hole, an ultrasonic wave may be applied to the plating solution.

The production method of the magnetic substrate according to the present embodiment may include a step (annealing step) of subjecting the magnetic layer and the electroplated layer to an annealing treatment after the electroplating. The treatment temperature range for the annealing treatment is preferably 150°C or higher, more preferably 160°C or higher, and still more preferably 170°C or higher, and is preferably 260°C or lower, more preferably 250°C or lower, and still more preferably 240°C or lower. The treatment time range for the annealing treatment is preferably 10 minutes or longer, more preferably 20 minutes or longer, and still more preferably 30 minutes or longer, and is preferably 10 hours or shorter, more preferably 5 hours or shorter, and still more preferably 2 hours or shorter. The annealing treatment may be performed in an inert atmosphere such as a nitrogen gas atmosphere. By performing the annealing treatment, it is possible to increase the adhesion strength between the magnetic layer and the electroplated layer.

By forming the electroplated layer on the surface of the magnetic layer as described above, the magnetic substrate including the magnetic layer and the electroplated layer that is formed on the surface of the magnetic layer can be obtained. For example, in the case that the electroplated layer is formed in a helical shape by itself, or in the case that the combination of the electroplated layer and an optional conductor layer possessed by the magnetic substrate is formed in a helical shape, it is possible to form an inductor by a conductor layer such as the electroplated layer and the optional conductor layer; thus, an inductor built-in substrate having an inductor can be obtained as the magnetic substrate.

There is no particular restriction with regard to the thickness of the electroplated layer; thus, an appropriate range thereof can be selected in accordance with the use thereof. In one example, the range of the thickness of the electroplated layer is preferably 1 µm or more, more preferably 3 µm or more, and still more preferably 5 µm or more, and is preferably 70 µm or less, more preferably 60 µm or less, and still more preferably 50 µm or less.

Preferably, it is possible that the electroplated layer thereby formed has a low surface roughness. The arithmetic average surface roughness Ra of the electroplated layer is preferably 2000 nm or less, more preferably 1000 nm or less, and still more preferably 800 nm or less. The lower limit thereof is not particularly restricted; the lower limit may be, for example, 1 nm or more, 10 nm or more, or 50 nm or more. The surface roughness of the electroplated layer can be measured using a non-contact type surface roughness meter.

### <Optional step>

The production method of the magnetic substrate according to the present embodiment may further include an optional step in combination with the steps described above.

The production method of the magnetic substrate may include, for example, a step of forming an optional conductor layer. To illustrate a specific example thereof, when an optional conductor layer other than the substrate conductor layer and the electroplated layer is desired to be formed on the magnetic substrate, the production method of the magnetic substrate may include a step for forming the optional conductor layer. Illustrative examples of the method for forming the optional conductor layer may include a plating method, a sputtering method, and a vapor deposition method. The optional conductor layer may be processed into an intended wiring pattern by a suitable method such as a semi-additive method or a full-additive method.

Hereinafter, one example of the method for forming the optional conductor layer will be described in detail. A thin conductor layer (seed layer) is formed by an electroless plating. Next, a conductor layer is further formed on the resulting seed layer by an electroplating. Then, as needed, by removing an unnecessary seed layer by a treatment such as etching, the optional conductor layer having an intended wiring pattern can be formed. After the optional conductor layer is formed, in order to improve the adhesion strength, an annealing treatment may be carried out, as needed.

The production method of the magnetic substrate may include, for example, a step of forming an optional insulating layer. To illustrate a specific example thereof, the optional insulating layer may be formed when the electroplated layer is desired to be insulated from other conductor layers. To illustrate another specific example thereof, when an electroplated layer is formed on the surface in the second hole of the magnetic layer, but the electroplated layer alone is not possible to fill the entire second hole, an insulating layer that fills the second hole may be formed. The insulating layer may be formed by a curd product of a thermosetting resin composition or by a curd product of a photo-curable resin composition. To illustrate a specific example thereof, the insulating layer may be formed by forming a layer of a thermosetting resin composition or a layer of a photo-curable resin composition on the magnetic substrate, which is followed by curing this layer.

In the production method of the magnetic substrate, the formation of the magnetic layer and the formation of the electroplated layer, as well as the formation of the optional conductor layer and the formation of the optional insulating layer described above may be repeated. To illustrate a specific example thereof, the magnetic layer and the electroplated layer may be alternately built up by repeating the formation of the magnetic layer and the formation of the electroplated layer.

### [Magnetic substrate]

The magnetic substrate produced by the production method described above includes the magnetic layer and the electroplated layer formed on the surface of this magnetic layer. There is no particular restriction with regard to the structure of the magnetic substrate as long as this has the magnetic layer and the electroplated layer. Therefore, there is no restriction with regard to the use of the magnetic substrate to be produced by the production method described above. From the viewpoint of utilizing the point that the electroplated layer can be formed on the surface of the magnetic layer by the electroplating, it is preferable that the magnetic substrate includes the magnetic layer having the second hole formed therein and the electroplated layer formed in the second hole.

For example, assume the case that the magnetic layer is formed on the main surface of the inner layer substrate and the conductor layer is formed on the main surface of this magnetic layer. In this case, it is possible to form the electroplated layer as the conductor layer on the main surface of the magnetic layer by the method described above, but it is also possible to form the conductor layer by using metallic foil such as copper foil, for example. Therefore, this conductor layer can be formed by a method other than the method according to the embodiment described above, with omitting the electroless plating.

However, when trying to form a conductor layer in the second hole formed in the magnetic layer, it is difficult to form the conductor layer by using the metal foil because the second hole is generally small. Therefore, forming the conductor layer in the second hole without using the electroless plating is impossible by any method other than the method according to the embodiment described above.

Therefore, from the viewpoint of providing a new magnetic substrate that has been unable to be realized by any method other than the production method according to the embodiment described above, and effectively utilizing the production method, it is preferable to produce the magnetic substrate that includes the magnetic layer having the second hole formed therein and the electroplated layer formed in the second hole by the above-mentioned production method. Hereinafter, an example of this magnetic substrate, along with its production method, will be described with referring to the drawings. However, the magnetic substrate and the production method thereof are not limited to the examples described below.

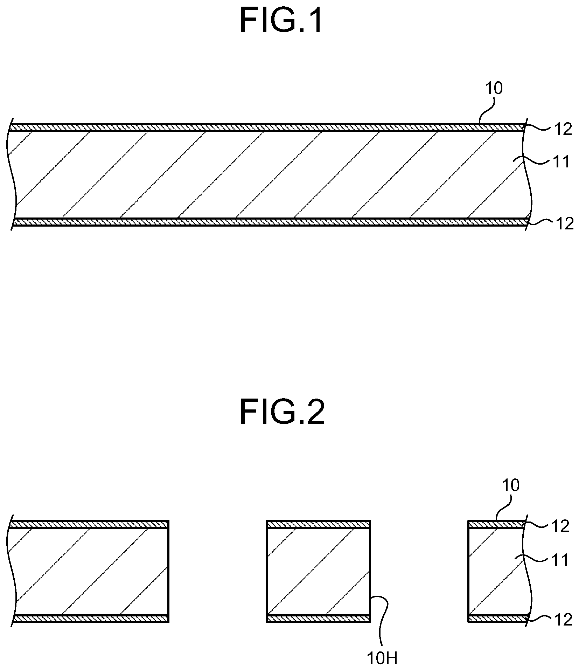

FIG. 1 to FIG. 12 are schematic cross-sectional views to explain each steps of the production method of the magnetic substrate according to one example. The production method of the magnetic substrate according to this example includes the step of preparing an inner layer substrate 10, as illustrated in FIG. 1. In this example, the plate-shaped inner layer substrate 10 including a supporting substrate 11 and substrate conductor layers 12 formed on both sides of the supporting substrate 11 will be described.

After preparing the inner layer substrate 10, the production method of the magnetic substrate according to this example includes the step of forming a first hole 10H as the through hole in the inner layer substrate 10, as illustrated in FIG. 2. The first hole 10H is formed so as to penetrate through the inner layer substrate 10 in the thickness direction. There is no particular restriction with regard to the diameter of the first hole 10H. The diameter may be, for example, in the range of 200 µm to 800 µm.

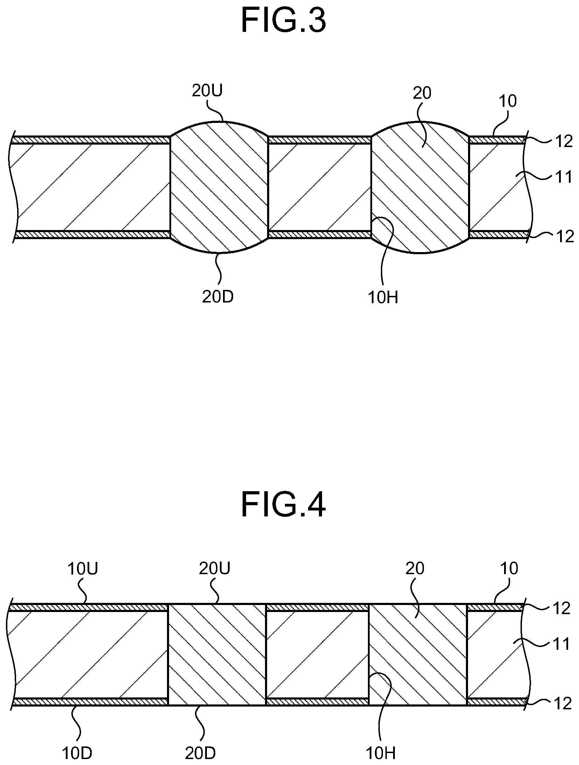

After forming the first hole 10H, the production method of the magnetic substrate according to this example includes the step of forming a resin composition layer 20 in the first hole 10H of the inner layer substrate 10 (step (LF)), as illustrated in FIG. 3. Usually, when the resin composition layer 20 is formed in the first hole 10H, an excess resin composition protrudes or adheres to the outside of the first hole 10H. Therefore, main surfaces 20U and 20D of the resin composition layer 20 formed at the opening of the first hole 10H are often raised, so that they are not flat.

After forming the resin composition layer 20, the production method of the magnetic substrate according to this example includes the step of polishing the resin composition layer 20 (step (PO)), as illustrated in FIG. 4. The polishing removes the excess resin composition protruding or adhering to the outside of the first hole 10H, so that the main surfaces 20U and 20D of the resin composition layer 20 can be flattened. Usually, the main surface 20U of the resin composition layer 20 after polishing is flush with one main surface 10U of the inner layer substrate 10, and the main surface 20D of the resin composition layer 20 after polishing is flush with the other main surface 10D of the inner layer substrate 10. Unless otherwise specifically noted, "flush" for a plurality of surfaces means that these surfaces are in the same plane.

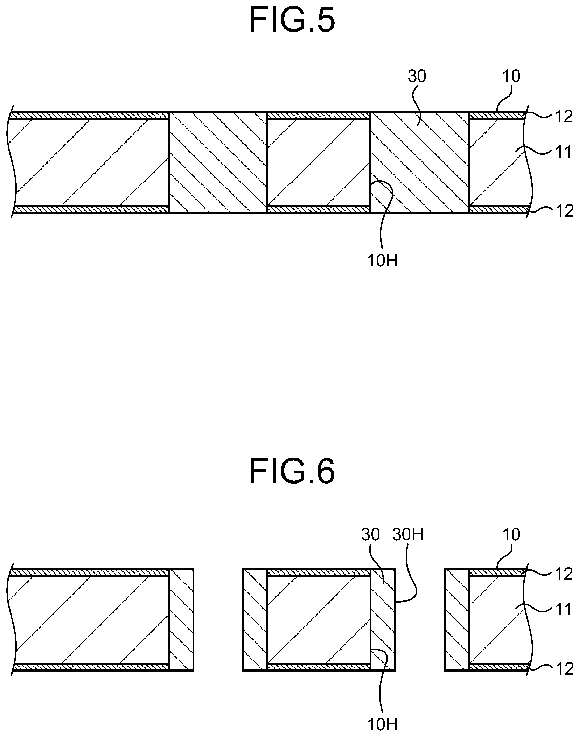

After forming the resin composition layer 20, the production method of the magnetic substrate according to this example includes the step of curing the resin composition layer 20 to obtain a magnetic layer 30 (step (CU)), as illustrated in FIG. 5. Here, an example is described in which curing is performed after polishing of the resin composition layer 20, but polishing of the magnetic layer 30 may be performed after this magnetic layer 30 is obtained by curing the resin composition layer 20.

After forming the magnetic layer 30, the production method of the magnetic substrate according to this example includes the step of forming a second hole 30H as the through hole in the magnetic layer 30 (step (HF)), as illustrated in FIG. 6. The second hole 30H is formed so as to penetrate through the magnetic layer 30 in the thickness direction. The diameter of the second hole 30H may be formed smaller than the diameter of the first hole 10H. Specifically, there is no particular restriction with regard to the dimension thereof.

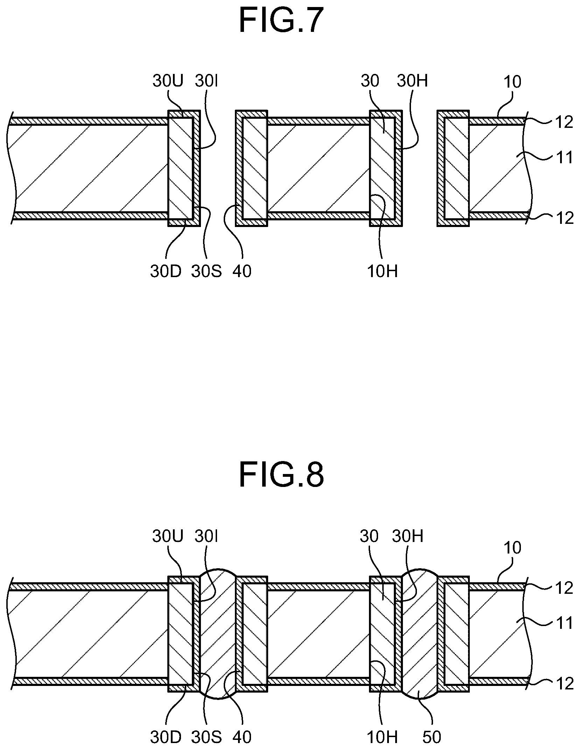

After forming the second hole 30H, the production method of the magnetic substrate according to this example includes the step of forming an electroplated layer 40 on a surface 30S of the magnetic layer 30 (step (EP)), as illustrated in FIG. 7. The magnetic layer 30 includes, as a surface 30S not bonded to the inner layer substrate 10, main surfaces 30U and 30D formed at the opening of the first hole 10H, and a hole inner circumferential surface 30I formed in the second hole 30H. The electroplated layer 40 is usually formed on both the main surfaces 30U and 30D of the magnetic layer 30 and on the hole inner circumferential surface 30I.

The whole of the second hole 30H may be filled by the electroplated layer 40, but there may be the case that part of the second hole 30H is not filled. When part of the second hole 30H is not filled by the electroplated layer 40, the production method of the magnetic substrate according to this example may include the step of forming an insulating layer 50 in that part in the electroplated layer 40 that is not filled by the electroplated layer 40, as illustrated in FIG. 8. The insulating layer 50 may be formed, for example, by filling the part with a curable resin such as a thermosetting resin composition or a photo-curable resin composition followed by curing it.

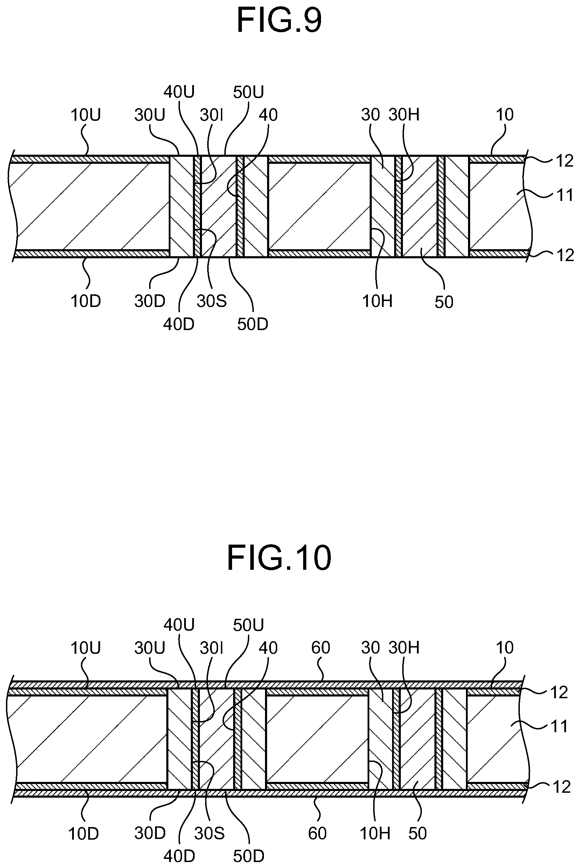

After forming the insulating layer 50, the insulating layer 50 may be polished. When polishing the insulating layer 50, the electroplated layer 40 may be polished at the same time. Here, an example in which the insulating layer 50 and the electroplated layer 40 are polished as illustrated in FIG. 9 will be explained. In this example, by this polishing, the main surface 10U of the inner layer substrate 10, the main surface 30U of the magnetic layer 30, the main surface 40U of the electroplated layer 40, and the main surface 50U of the insulating layer 50 are made to be flush with each other. Also, the main surface 10D of the inner layer substrate 10, the main surface 30D of the magnetic layer 30, the main surface 40D of the electroplated layer 40, and the main surface 50D of the insulating layer 50 are made to be flush with each other.

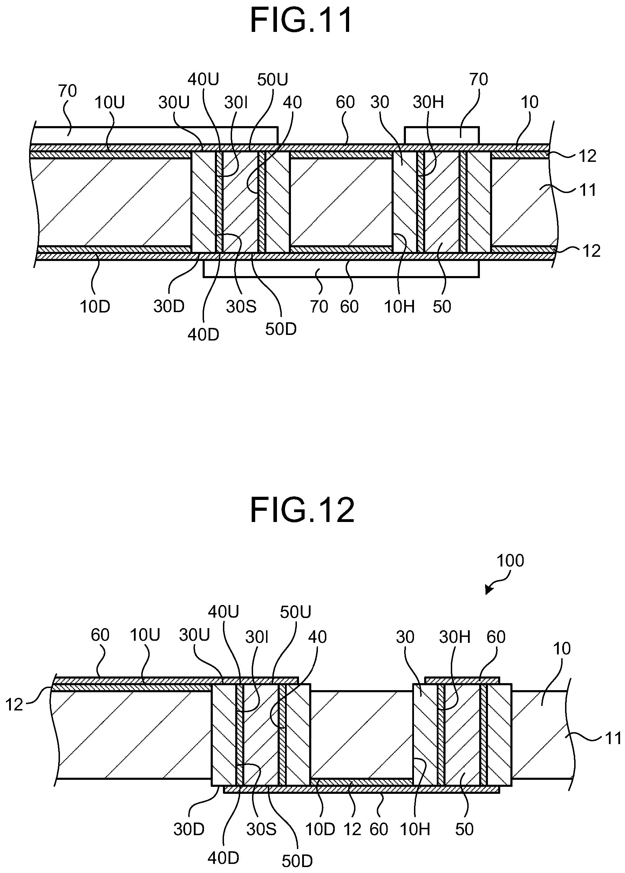

After forming the electroplated layer 40, the production method of the magnetic substrate according to this example may include the step of forming an optional conductor layer 60 on the inner layer substrate 10, on the magnetic layer 30, on the electroplated layer 40, and on the insulating layer 50, as illustrated in FIG. 10. The optional conductor layer 60 may be formed, for example, by an electroless plating and by an electroplating. Then, an etching resist 70 having an intended pattern is formed on the optional conductor layer 60, as illustrated in FIG. 11. Then, the substrate conductor layer 12, the electroplated layer 40, and the optional conductor layer 60 in the area not covered by the etching resist 70 are removed, and then the etching resist 70 is removed.

FIG. 12 is the schematic cross-sectional view of the magnetic substrate according to one example. By carrying out the steps described above, the magnetic substrate 100 illustrated in FIG. 12 can be obtained. In this case, by forming the conductor layers such as the substrate conductor layer 12, the electroplated layer 40, and the optional conductor layer 60 in a helical shape as a whole, an inductor can be formed by these conductor layers, so that an inductor built-in substrate can be obtained as the magnetic substrate 100. The production method according to this example may further form a conductor layer other than the substrate conductor layer 12, the electroplated layer 40, and the optional conductor layer 60.

As illustrated in FIG. 12, the magnetic substrate 100 includes the magnetic layer 30 having the second hole 30H formed therein and the electroplated layer 40 formed on the surface 30S of this magnetic layer 30. In this example, at least part of the electroplated layer 40 is formed in the second hole 30H. Because the electroplated layer 40 is formed without conducting an electroless plating, the electroplated layer 40 formed in the second hole 30H is in direct contact with the magnetic layer 30. There is no plating catalyst for the electroless plating at the interface between the electroplated layer 40 and the magnetic layer 30 (corresponding to the hole inner circumferential surface 30I), which are in contact as described above. Formation of the conductor layer without using the plating catalyst on the surface of the magnetic layer in the second hole formed in the magnetic layer has not been realized by a conventional technology. Therefore, the aforementioned magnetic substrate 100 has not been unknown, neither in its production method nor in its structure.

The magnetic substrate described above may be used, for example, to produce an inductor component. The inductor component includes the magnetic substrate described above. The inductor component usually has an inductor pattern formed of the conductor layers such as the substrate conductor layer, the electroplated layer, and the optional conductor layer, in at least part around the magnetic layer described above. As for the inductor component described above, for example, the one described in Japanese Patent Application Laid-open No. 2016-197624 may be used. The inductor component includes the inductor built-in substrate described above.

The inductor component may be used as a wiring board to mount an electronic component such as a semiconductor chip, and may also be used as a (multilayered) printed wiring board that uses this wiring board as an inner layer substrate. In addition, for example, this may also be used as a chip inductor component obtained by dicing the wiring board, and may also be used as a printed wiring board having the chip inductor component surface-mounted.

In addition, by using this wiring board, semiconductor devices with various embodiments may be produced. The semiconductor device including the wiring board may be suitably used in electric products (for example, a computer, a mobile phone, a digital camera, and a television), vehicles (for example, a motor bike, an automobile, a train, a marine ship, and an airplane), and so forth.

### [Examples]

Hereinafter, the present invention will be specifically described by Examples. The present invention is not limited to these Examples. In the description below, "part" and "%" that describe quantity mean "part by mass" and "% by mass", respectively, unless otherwise specifically mentioned. Unless otherwise specifically mentioned, the following operations were performed at normal temperature and normal pressure (23°C and 1 atm). In addition, the volume content (% by volume) was determined by calculation using a mass and a specific gravity.

### <Example 1: Production of magnetic varnish 1>

1.92 parts by mass of the epoxy resin ("ZX-1059" manufactured by Nippon Steel Chemical & Materials Co., Ltd.; a mixture of bisphenol A type epoxy resin and bisphenol F type epoxy resin; epoxy equivalent of 169 g/eq.), 2.18 parts by mass of the phenol resin containing a triazine skeleton ("LA-7054" manufactured by DIC Corp.; hydroxyl group equivalent of about 125 g/eq.; MEK solution with 60% solid content), 1.67 parts by mass of the phenoxy resin ("YL7553BH30" manufactured by Mitsubishi Chemical Corp.; 1:1 MEK/cyclohexanone solution with 30% solid content), 0.43 parts by mass of the dispersant ("PB-821" manufactured by Ajinomoto Fine-Techno Co., Ltd., cationic dispersant), 3 parts by mass of the solvent (cyclohexanone), 22.09 parts by mass of the ferrite powder ("M03S" manufactured by Powdertech, Inc.; Fe-Mn type ferrite; average particle diameter of 0.5 µm; specific gravity of 5.1 m²/g), and 73.74 parts by mass of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) were mixed to produce a magnetic vanish 1.

### <Example 2: Production of magnetic varnish 2>

The amount of the ferrite powder ("M03S" manufactured by Powdertech, Inc.; Fe-Mn type ferrite; average particle diameter of 0.5 µm; specific gravity of 5.1 m²/g) was changed from 22.09 parts by mass to 30.00 parts by mass. The amount of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) was changed from 73.74 parts by mass to 30.00 parts by mass. A magnetic varnish 2 was produced in the same way as in Example 1 except for the above-mentioned matters.

### <Example 3: Production of magnetic varnish 3>

The amount of the ferrite powder ("M03S" manufactured by Powdertech, Inc.; Fe-Mn type ferrite; average particle diameter of 0.5 µm; specific gravity of 5.1 m²/g) was changed from 22.09 parts by mass to 50.00 parts by mass. The amount of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) was changed from 73.74 parts by mass to 22.00 parts by mass. A magnetic varnish 3 was produced in the same way as in Example 1 except for the above-mentioned matters.

### <Example 4: Production of magnetic varnish 4>

A magnetic varnish 4 was produced in the same way as in Example 1, except that 22.09 parts by mass of the ferrite powder ("M03S" manufactured by Powdertech, Inc.; Fe-Mn type ferrite; average particle diameter of 0.5 µm; specific gravity of 5.1 m²/g) was changed to 30.92 parts by mass of the alloy powder (fine alloy powder "CVD Iron Powder" manufactured by JFE Mineral & Alloy Co., Ltd., Fe-Cr-Si type alloy, average particle diameter of 0.7 µm, specific gravity of 6.9 m²/g).

### <Example 5: Production of magnetic varnish 5>

A magnetic varnish 5 was produced in the same way as in Example 1, except that 22.09 parts by mass of the ferrite powder ("M03S" manufactured by Powdertech, Inc.; Fe-Mn type ferrite; average particle diameter of 0.5 µm; specific gravity of 5.1 m²/g) was changed to 22.09 parts by mass of the ferrite powder ("MZ03S" manufactured by Powdertech, Inc.; Fe-Mn-Zn type ferrite, average particle diameter of 0.5 µm, specific gravity of 5.1 m²/g).

### <Example 6: Production of magnetic varnish 6>

A magnetic varnish 6 was produced in the same way as in Example 1, except that 73.74 parts by mass of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) was changed to 73.74 parts by mass of the alloy powder ("AKT-PB-3Si(5)" manufactured by Mitsubishi Steel Mfg. Co., Ltd.; Fe-Ni-Si type alloy; average particle diameter of 5.0 µm; specific gravity of 8.0 m²/g).

### <Example 7: Production of magnetic varnish 7>

A magnetic varnish 7 was produced in the same way as in Example 1, except that 73.74 parts by mass of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) was changed to 50.00 parts by mass of the alloy powder ("AW2-08 PF3F" manufactured by Epson Atmix Corp.; Fe-Si-Cr type alloy; average particle diameter of 3.0 µm; specific gravity of 6.9 m²/g) .

### <Example 8: Preparation of magnetic paste 8>

1.70 parts by mass of the epoxy resin ("ZX-1059" manufactured by Nippon Steel Chemical & Materials Co., Ltd.; a mixture of bisphenol A type epoxy resin and bisphenol F type epoxy resin; epoxy equivalent of 169 g/eq.), 1.42 parts by mass of the epoxy resin ("630" manufactured by Mitsubishi Chemical Corp.; glycidylamine type epoxy resin; epoxy equivalent of 95 g/eq.), 4.90 parts by mass of the epoxy resin ("ZX-1658GS" manufactured by Nippon Steel Chemical & Materials Co., Ltd.; alicyclic diglycidyl ether; epoxy equivalent of 135 g/eq.), 0.57 parts by mass of the dispersant ("PB-821" manufactured by Ajinomoto Fine-Techno Co., Ltd., cationic dispersant), 0.47 parts by mass of the curing accelerator ("2MZA-PW" manufactured by Shikoku Chemicals Corp.; imidazole type epoxy resin curing accelerator), 17.75 parts by mass of the ferrite powder ("M03S" manufactured by Powdertech, Inc.; Fe-Mn type ferrite; average particle diameter of 0.5 µm; specific gravity of 5.1 m²/g), and 59.09 parts by mass of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) were mixed to produce a magnetic paste 8.

### <Example 9: Production of magnetic ink 9>

4.6 parts by mass of the epoxy resin ("ZX-1059" manufactured by Nippon Steel Chemical & Materials Co., Ltd.; a mixture of bisphenol A type epoxy resin and bisphenol F type epoxy resin; epoxy equivalent of 169 g/eq.), 1.42 parts by mass of the epoxy resin ("630" manufactured by Mitsubishi Chemical Corp.; glycidylamine type epoxy resin; epoxy equivalent of 95 g/eq.), 2.0 parts by mass of the epoxy resin ("ZX-1658GS" manufactured by Nippon Steel Chemical & Materials Co., ltd.; alicyclic diglycidyl ether; epoxy equivalent of 135 g/eq.), 0.57 parts by mass of the dispersant ("PB-821" manufactured by Ajinomoto Fine-Techno Co., Ltd., cationic dispersant), 0.47 parts by mass of the curing accelerator ("2MZA-PW" manufactured by Shikoku Chemicals Corp.; imidazole type epoxy resin curing accelerator), 1.0 parts by mass of the solvent (butylcarbitol acetate), 17.75 parts by mass of the ferrite powder ("M03S" manufactured by Powdertech, Inc.; Fe-Mn type ferrite; average particle diameter of 0.5 µm; specific gravity of 5.1 m²/g), and 59.09 parts by mass of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) were mixed to produce a magnetic ink 9.

### <Comparative Example 1: Production of magnetic varnish 10>

The amount of the ferrite powder ("M03S" manufactured by Powdertech, Inc.; Fe-Mn type ferrite; average particle diameter of 0.5 µm; specific gravity of 5.1 m²/g) was changed from 22.09 parts by mass to 50.00 parts by mass. The amount of the alloy powder ("AKT-PB(5)" manufactured by Mitsubishi Steel Mfg. Co., Ltd.; Fe-Ni type alloy; average particle diameter of 5.0 µm; specific gravity of 8.0 m²/g) was changed from 73.74 parts by mass to 8.00 parts by mass. Besides, 3 parts by mass of the solvent (cyclohexanone) was not used. A magnetic varnish 10 was produced in the same way as in Example 1 except for the above-mentioned matters.

### <Production of resin sheet>

A PET film ("Lumirror R80" manufactured by Toray Industries, Inc.; thickness of 38 µm; softening temperature of 130°C; hereinafter, this may be referred to as "release PET") that had been subjected to releasing treatment with an alkyd resin type releasing agent ("AL-5" manufactured by Lintec Inc.) was prepared as the support. Onto this support, the resin varnishes 1 to 7 and 10 produced in Examples 1 to 7 and Comparative Example 1 each were applied using a die coater such that the thickness of the resin composition layer after drying would become 100 µm, which was then followed by drying at 65°C to 115°C (average 100°C) for 7 minutes to obtain a resin sheet.

### <Electroplating test 1: formation of conductor layer by electroplating using resin sheet>

Both sides of a double-sided copper clad epoxy resinimpregnated glass cloth substrate ("R5715ES" manufactured by Panasonic Corp.; thickness of the copper foil: 18 µm, thickness of the substrate: 0.3 mm) were etched by 1 µm using a micro-etching agent ("CZ8100" manufactured by MEC Co., Ltd.) for roughening the copper surface to prepare the inner layer substrate.

From each of the resin sheets produced in Examples 1 to 7 and Comparative Example 1, a regular square sheet piece of a 200 mm square was cut out. The cut-out sheet piece (200 mm square) was laminated onto both surfaces of the inner layer substrate by using a batch-type vacuum pressure laminator (two-stage build-up laminator, "CVP700" manufactured by Nikko-Materials Co., Ltd.) such that the resin composition layer would be in contact with the center of the inner layer substrate. The lamination was carried out by evacuating over 30 seconds to bring the pressure to 13 hPa or less, followed by press-bonding with the pressure of 0.74 MPa at 100°C for 30 seconds. Then, after heating at 130°C for 30 minutes, this was further heated at 180°C for 30 minutes to thermally cure the resin composition layer to form the magnetic layer. The surface of the resulting magnetic layer was buff-polished.

Onto the surface of the magnetic layer that had been subjected to the polishing treatment, copper sulfate electroplating was applied as electroplating. The electroplating was performed using the magnetic layer as the cathode and a copper plate as the anode, by flowing an electric current with a current density of 2.0 A/dm² in a copper sulfate solution as the plating solution for 60 minutes. The composition of the plating solution was as follows.
"Copper sulfate pentahydrate" manufactured by Wako Pure Chemical Industries, Ltd.: 79 g/L
"Sulfuric acid" manufactured by Wako Pure Chemical Industries, Ltd.: 154 mL/L
"Sodium chloride" manufactured by Wako Pure Chemical Industries, Ltd.: 65 mg/L
"Additive Cupracid HL" manufactured by Atotech Japan K.K., surfactant: 30 mL/L
"Correction Cupracid GS" manufactured by Atotech Japan K.K., organosulfur compound: 0.1 mL/L

After the electroplating as described above, the annealing treatment was performed at 180°C for 60 minutes to obtain an evaluation substrate. The resulting evaluation substrate was observed to determine whether or not the conductor layer (electroplated layer) was formed on the surface of the magnetic layer. The evaluation was made "Good" when the electroplated layer was formed over the entire surface of the magnetic layer, and "Not Good" when the electroplated layer was not formed.

### <Electroplating test 2: formation of conductor layer by electroplating using magnetic paste or magnetic ink>

Both sides of a double-sided copper clad epoxy resinimpregnated glass cloth substrate ("R5715ES" manufactured by Panasonic Corp.; thickness of the copper foil: 18 µm, thickness of the substrate: 0.3 mm) were etched by 1 µm using a micro-etching agent ("CZ8100" manufactured by MEC Co., Ltd.) for roughening the copper surface to prepare the inner layer substrate.

The magnetic paste produced in Example 8 and the magnetic ink produced in Example 9 each were uniformly applied onto the above-mentioned inner layer substrate using a doctor blade to form a resin composition layer such that the thickness of the magnetic layer after curing would become 100 µm. Then, after heating at 130°C for 30 minutes, this was further heated at 150°C for 30 minutes to thermally cure the resin composition layer to form the magnetic layer. After the surface of the resulting magnetic layer was buff-polished, the curing further proceeded by heating treatment at 180°C for 30 minutes.

Onto the surface of the magnetic layer that had been subjected to the polishing treatment, copper sulfate electroplating was applied as electroplating. The electroplating was performed in the same way as in the electroplating test 1 described before. After the electroplating, the annealing treatment was performed at 180°C for 60 minutes to obtain an evaluation substrate. The resulting evaluation substrate was observed to determine whether or not the conductor layer (electroplated layer) was formed on the surface of the magnetic layer. The evaluation was made "Good" when the electroplated layer was formed over the entire surface of the magnetic layer, and "Not Good" when the electroplated layer was not formed.

### <Magnetic property test 1: measurement of relative magnetic permeability and magnetic loss tangent of magnetic layer obtained from resin sheet>

From each of the resin sheets produced in Examples 1 to 7 and Comparative Example 1, a regular square sheet piece of a 200 mm square was cut out. The cut-out sheet piece (200 mm square) was laminated using a batch-type vacuum pressing laminator ("CVP700" manufactured by Nikko-Materials Co., Ltd.; two-stage build-up laminator) onto one surface of a polyimide film ("Iupilex 25S" manufactured by UBE Corp.; thickness of 25 µm, 240 mm square). The lamination was carried out such that the resin composition layer of the sheet piece would be in contact with the center of the smooth surface of the polyimide film. The lamination was carried out by evacuating over 30 seconds to bring the pressure to 13 hPa or less, followed by press-bonding with the pressure of 0.74 MPa at 100°C for 30 seconds. With this lamination, a multi-layer film having a layered structure of support/resin composition layer/polyimide film was obtained.

After the support was removed, the resin composition layer was heated at 190°C for 90 minutes for thermal curing. The polyimide film was then removed to obtain the sheet-shaped cured product. This cured product corresponds to the magnetic layer obtained from the resin sheet. The resulting sheet-shaped cured product was cut to obtain the doughnut-shaped evaluation sample having the outer diameter of 19.2 mm and the inner diameter of 8.2 mm. The relative magnetic permeability (µ') and the magnetic loss tangent (tanδ) of the evaluation sample were measured using a magnetic material test fixture "16454A" manufactured by Keysight Technologies Inc. and an impedance analyzer "E4991B" manufactured by Keysight Technologies Inc. at the measurement frequency of 20 MHz and at a room temperature of 23°C. The magnetic loss tangent tanδ was calculated by the following formula [tanδ = µ"/µ'].

### <Magnetic property test 2: measurement of relative magnetic permeability and magnetic loss tangent of magnetic layer obtained from magnetic paste or magnetic ink>

A polyethylene terephthalate (PET) film ("PET501010", manufactured by Lintech Corp., thickness of 50 µm) having been treated with a silicone type release agent was prepared as the support. The magnetic paste produced in Example 8 and the magnetic ink produced in Example 9 each were uniformly applied onto the release surface of the above-mentioned PET film using a doctor blade such that the thickness of the magnetic layer after curing would be 100 µm to obtain a resin sheet including the support and the resin composition layer.

The resulting resin sheet was heated at 190°C for 90 minutes to thermally cure the resin composition layer. The support was then removed to obtain a sheet-shaped cured product. This cured product corresponds to the magnetic layer obtained from the magnetic paste or from the magnetic ink. The resulting sheet-shaped cured product was cut to obtain the doughnut-shaped evaluation sample having the outer diameter of 19.2 mm and the inner diameter of 8.2 mm. The relative magnetic permeability (µ') and the magnetic loss tangent (tanδ) of the evaluation sample were measured using a magnetic material test fixture "16454A" manufactured by Keysight Technologies Inc. and an impedance analyzer "E4991B" manufactured by Keysight Technologies Inc. at the measurement frequency of 20 MHz and at a room temperature of 23°C. The magnetic loss tangent tanδ was calculated by the following formula [tanδ = µ"/µ'].

### <Resistance measurement test: measurement of volume resistance of magnetic layer>

The sheet-shaped cured product was obtained by the same method as in the magnetic property tests 1 and 2. The resulting sheet-shaped cured product was cut to obtain the evaluation sample having the size of 10 cm square. The volume resistivity of the sample was measured using an insulation resistivity tester "R8340" manufactured by Advantest Corp.

### <Surface roughness measurement test: measurement of surface roughness of electroplated layer>

The arithmetic average roughness values Ra of the electroplated layers formed in the electroplating test 1 and the electroplating test 2 described above were obtained using a non-contact surface roughness meter (WYKO NT3300 manufactured by Veeco Instruments Inc.) with VSI mode using a lens of 50 magnifications with the measurement area of 121 µm × 92 µm; from this, the Ra value was determined. The value was determined as the average value of 10 randomly selected areas.

### <Results>

The results of Examples and Comparative Examples are summarized in Tables below. In the Tables, the abbreviations have the following meanings.
CH: Cyclohexanone
BCA: Butylcarbitol acetate

Magnetic powder amount (% by weight): Amount of (A) the magnetic powder relative to 100% by mass of nonvolatile components in the resin composition.

Magnetic powder amount (% by volume): Amount of (A) the magnetic powder relative to 100% by volume of the nonvolatile components in the resin composition.

Alloy powder amount (% by weight): Amount of (A-1) the alloy powder relative to 100% by mass of the nonvolatile components in the resin composition.

Alloy powder amount (% by volume): Amount of (A-1) the alloy powder relative to 100% by volume of nonvolatile components in the resin composition.

Alloy powder/magnetic powder (% by weight): Amount of (A-1) the alloy powder relative to 100% by mass of (A) the magnetic powder.

Alloy powder/magnetic powder (% by volume): Amount of (A-1) the alloy powder relative to 100% by volume of (A) the magnetic powder.

Plating formation: Whether the electroplated layer was formed by electroplating or not.

Relative magnetic permeability: Relative magnetic permeability of the cured product of the resin composition corresponding to the magnetic layer.

Magnetic loss tangent: Magnetic loss tangent of the cured product of the resin composition corresponding to the magnetic layer.

Volume resistance: Volume resistance of the magnetic layer.

Surface roughness: Surface roughness of the electroplated layer.

**[Table 1]**

| **[Table 1. Results of Examples 1 to 5]** | | | | | | |
|---|---|---|---|---|---|---|
| | | Example | | | | |
| | | 1 | 2 | 3 | 4 | 5 |
| (A-1) | AKT-PB(5) | 73.74 | 30.00 | 22.00 | 73.74 | 73.74 |
| | AKT-PB-3Si | | | | | |
| | AW2-08 PF3F | | | | | |
| | CVD Iron Powder | | | | 30.92 | |
| (A-2) | M03S | 22.09 | 30.00 | 50.00 | | |
| | MZ03S | | | | | 22.09 |
| (B-1) | ZX-1059 | 1.92 | 1.92 | 1.92 | 1.92 | 1.92 |
| | 630 | | | | | |
| | ZX-1658GS | | | | | |
| (B-2) | LA-7054 | 2.18 | 2.18 | 2.18 | 2.18 | 2.18 |
| (C) | 2MZA-PW | | | | | |
| (D) | YX7553BH30 | 1.67 | 1.67 | 1.67 | 1.67 | 1.67 |
| (E) | PB821 | 0.43 | 0.43 | 0.43 | 0.43 | 0.43 |
| (G) | CH | 3.00 | 3.00 | 3.00 | 3.00 | 3.00 |
| | BCA | | | | | |
| Total composition (parts by mass) | | 105.03 | 69.20 | 81.20 | 113.86 | 105.03 |
| Total nonvolatile components (parts by mass) | | 99.98 | 64.16 | 76.16 | 108.82 | 99.98 |
| Magnetic powder amount (% by weight) | | 96% | 94% | 95% | 96% | 96% |
| Magnetic powder amount (% by volume) | | 80% | 73% | 78% | 80% | 80% |
| Alloy powder amount (% by weight) | | 74% | 47% | 29% | 96% | 74% |
| Alloy powder amount (% by volume) | | 54% | 29% | 17% | 80% | 54% |
| Alloy powder/magnetic powder (% by weight) | | 77% | 50% | 31% | 100% | 77% |
| Alloy powder/magnetic powder (% by volume) | | 68% | 39% | 22% | 100% | 68% |
| Form of material | | Film | Film | Film | Film | Film |
| Plating formation | | Good | Good | Good | Good | Good |
| Relative magnetic permeability µ' | | 22 | 20 | 18 | 19 | 23 |
| Magnetic loss tangent tanδ | | 0.03 | 0.03 | 0.02 | 0.01 | 0.03 |
| Volume resistance (×10⁹ Ω·m) | | 3.78 | 6.23 | 41.2 | 3.47 | 3.59 |
| Surface roughness (nm) | | 115 | 336 | 688 | 94 | 108 |

**[Table 2]**

| **[Table 2. Results of Examples 6 to 9 and Comparative Example 1]** | | | | | | |
|---|---|---|---|---|---|---|
| | | Example | | | | Comparative Example |
| | | 6 | 7 | 8 | 9 | 1 |
| (A-1) | AKT-PB(5) | | | 59.09 | 59.09 | 8.00 |
| | AKT-PB-3Si | 73.74 | | | | |
| | AW2-08 PF3F | | 50.00 | | | |
| | CVD Iron Powder | | | | | |
| (A-2) | M03S | 22.09 | 22.09 | 17.75 | 17.75 | 50.00 |
| | MZ03S | | | | | |
| (B-1) | ZX-1059 | 1.92 | 1.92 | 1.70 | 4.60 | 1.92 |
| | 630 | | | 1.42 | 1.42 | |
| | ZX-1658GS | | | 4.90 | 200 | |
| (B-2) | LA-7054 | 2.18 | 2.18 | | | 2.18 |
| (C) | 2MZA-PW | | | 0.47 | 0.47 | |
| (D) | YX7553BH30 | 1.67 | 1.67 | | | 1.67 |
| (E) | PB821 | 0.43 | 0.43 | 0.57 | 0.57 | 0.43 |
| (G) | CH | 3.00 | 3.00 | | | |
| | BCA | | | | 1.00 | |
| Total composition (parts by mass) | | 105.03 | 81.29 | 85.90 | 86.90 | 64.20 |
| Total nonvolatile components (parts by mass) | | 99.98 | 76.24 | 85.90 | 85.90 | 62.16 |
| Magnetic powder amount (% by weight) | | 96% | 95% | 89% | 89% | 93% |
| Magnetic powder amount (% by volume) | | 80% | 77% | 59% | 59% | 76% |
| Alloy powder amount (% by weight) | | 74% | 66% | 69% | 69% | 13% |
| Alloy powder amount (% by volume) | | 54% | 48% | 40% | 40% | 7% |
| Alloy powder/magnetic powder (% by weight) | | 77% | 69% | 77% | 77% | 14% |
| Alloy powder/magnetic powder (% by volume) | | 68% | 63% | 68% | 68% | 9% |
| Form of material | | Film | Film | Paste | Ink | Film |
| Plating formation | | Good | Good | Good | Good | Not Good |
| Relative magnetic permeability µ' | | 22 | 21 | 16 | 16 | 14 |
| Magnetic loss tangent tanδ | | 0.02 | 0.02 | 0.02 | 0.02 | 0.02 |
| Volume resistance (×10⁹ Ω·m) | | 3.23 | 4.77 | 3.66 | 4.12 | 38.8 |
| Surface roughness (nm) | | 137 | 365 | 649 | 683 | - |

### Reference Signs List

10 inner layer substrate
10H first hole
10U and 10D main surface of inner layer substrate
11 supporting substrate
12 substrate conductor layer
20 resin composition layer
20U and 20D main surface of resin composition layer
30 magnetic layer
30H second hole
30S surface of magnetic layer
30U and 30D main surface of magnetic layer
30I hole inner circumferential surface of magnetic layer
40 electroplated layer
50 insulating layer
60 optional conductor layer
70 etching resist
100 magnetic substrate

## Claims

1. A production method of a magnetic substrate that comprises a magnetic layer and a conductor layer formed on a surface of the magnetic layer, wherein
the method comprises a step (EP) of forming the conductor layer on the surface of the magnetic layer by an electroplating,
the magnetic layer comprises a cured product of a resin composition comprising (A) a magnetic powder and (B) a thermosetting resin, and
(A) the magnetic powder comprises 30% by mass or more of (A-1) an alloy powder relative to 100% by mass of (A) the magnetic powder.

2. The production method of the magnetic substrate according to claim 1, the method comprising, before the step (EP):
a step (LF) of forming a resin composition layer that comprises the resin composition; and
a step (CU) of curing the resin composition layer to form the magnetic layer.

3. The production method of the magnetic substrate according to claim 2, wherein the method does not include, between the step (CU) and the step (EP), a step of forming the conductor layer on the surface of the magnetic layer by a method other than the electroplating.

4. The production method of the magnetic substrate according to claim 2, wherein the step (LF) comprises formation of the resin composition layer in a first hole of a substrate having the first hole formed therein.

5. The production method of the magnetic substrate according to claim 1, wherein
the method comprises a step (HF) of forming a second hole in the magnetic layer before the step (EP), and
the step (EP) comprises formation of the conductor layer by the electroplating on a surface of the second hole in the magnetic layer.

6. The production method of the magnetic substrate according to claim 1, wherein an amount of (A) the magnetic powder relative to 100% by mass of nonvolatile components in the resin composition is 60% by mass or more.

7. The production method of the magnetic substrate according to claim 1, wherein a relative magnetic permeability of the cured product at a measurement frequency of 20 MHz is 10 or more.

8. The production method of the magnetic substrate according to claim 1, wherein (A-1) the alloy powder comprises one or more alloy powder selected from the group consisting of a Fe-Ni type alloy powder, a Fe-Cr-Si type alloy powder, and a Fe-Ni-Cr type alloy powder.

9. A magnetic substrate comprising:
a magnetic layer having a hole formed therein; and
a conductor layer formed in the hole, wherein
the magnetic layer and the conductor layer are in direct contact with each other, and there is no plating catalyst at an interface between the magnetic layer and the conductor layer,
the magnetic layer comprises a cured product of a resin composition comprising (A) a magnetic powder and (B) a thermosetting resin, and
(A) the magnetic powder comprises 30% by mass or more of (A-1) an alloy powder relative to 100% by mass of (A) the magnetic powder.

10. The magnetic substrate according to claim 9, wherein the conductor layer is formed of copper.
